# EUROPEAN PATENT APPLICATION

(11) **EP 4 385 805 A1**
(43) Date of publication of application: **19.06.2024**
(21) Application number: 21957923.2
(22) Date of filing: 24.09.2021
(51) Int. Cl.: B60L 53/16, G01R 19/00

(54) **PLUGGING STATE DETECTION METHOD AND APPARATUS**

(71) Applicant: Huawei Technologies Co., Ltd., Shenzhen, Guangdong 518129 (CN)
(72) Inventor: LIU, Zhouyang, Shenzhen, Guangdong 518129 (CN); ZHANG, Xinlong, Shenzhen, Guangdong 518129 (CN); LI, Quan, Shenzhen, Guangdong 518129 (CN); FENG, Hui, Shenzhen, Guangdong 518129 (CN)
(74) Representative: MERH-IP Matias Erny Reichl Hoffmann Patentanwälte PartG mbB
(86) International application number: PCT/CN2021/120444
(87) International publication number: WO 2023/044798

(57) **Abstract**

This application provides a method and an apparatus for detecting a gun mounting status. In the technical solutions provided in this application, a charging device obtains a first voltage value at a first connection confirmation detection point and a second voltage value at a second connection confirmation detection point in a control and guiding circuit of a first charging gun, and obtains a third voltage value at a first connection confirmation detection point and a fourth voltage value at a second connection confirmation detection point in a control and guiding circuit of a first charging socket; and then determines a gun mounting status of the first charging gun and a gun mounting status of the first charging socket based on the first voltage value, the second voltage value, the third voltage value, and the fourth voltage value. According to the method, accuracy of detecting the gun mounting status of the first charging gun and the gun mounting status of the first charging socket can be improved.

## Description

### TECHNICAL FIELD

This application relates to the field of vehicle charging technologies, and more specifically, to a method and an apparatus for detecting a gun mounting status.

### BACKGROUND

With popularization of electric vehicles, a large quantity of charging devices that provide power endurance for the electric vehicles also appear in people's field of view. For example, a common charging device includes a direct-current charging gun and a direct-current charging socket. The direct-current charging gun may be plugged into a direct-current charging socket of the electric vehicle or another device that needs to be charged, to charge the electric vehicle or the another device that needs to be charged. A direct-current charging gun of another power supply device may be plugged into the direct-current charging socket to charge the charging device.

In a process of using the charging device, a plugging status of the direct-current charging gun and a plugging status of the direct-current charging socket of the charging device need to be detected.

Based on a stipulation in the national standard "GBT 18487.1-2015 Electric Vehicle Conductive Charging System", a voltage value at a connection confirmation detection point in a control and guiding circuit (that is, a voltage value at a CC1 in the control and guiding circuit) of the direct-current charging gun may be detected to determining the plugging status of the direct-current charging gun, and a voltage value at a connection confirmation detection point in a control and guiding circuit (that is, a voltage value at a CC2 in the control and guiding circuit) of the direct-current charging socket may be detected to determine the plugging status of the direct-current charging socket.

However, the foregoing method for detecting the plugging status of the direct-current charging gun and the plugging status of the direct-current charging socket cannot be used to accurately detect the plugging status of the direct-current charging gun and the plugging status of the direct-current charging socket of the charging device. For example, voltage values obtained at the CC1 and the CC2 when the direct-current charging gun of the charging device is plugged into the direct-current charging socket of the charging device and a mechanical lock on the direct-current charging gun of the charging device is pressed are respectively the same as voltage values obtained at the CC1 and the CC2 when the direct-current charging gun of the charging device leaves the direct-current charging socket of the charging device and the mechanical lock on the direct-current charging gun of the charging device is released, and a direct-current charging gun of another power supply device is plugged into the direct-current charging socket of the charging device and a mechanical lock on the direct-current charging gun of the another power supply device is pressed, where the voltage value at the CC1 is 6 volts, and the voltage value at the CC2 is 6 volts. Therefore, when a mobile charging device detects that the voltage at the CC1 is 6 volts and the voltage at the CC2 is 6 volts, the charging device cannot accurately determine plugging statuses of the direct-current charging gun and the direct-current charging socket of the charging device.

### SUMMARY

This application provides a method and an apparatus for detecting a gun mounting status, to improve accuracy of detecting a gun mounting status of a charging gun of a charging device and a gun mounting status of a charging socket of the charging device.

According to a first aspect, an embodiment of this application provides a method for detecting a gun mounting status, applied to a charging device. The charging device includes a first charging gun and a first charging socket, and the method includes: obtaining a first voltage value at a first connection confirmation detection point and a second voltage value at a second connection confirmation detection point in a control and guiding circuit of the first charging gun; obtaining a third voltage value at a first connection confirmation detection point and a fourth voltage value at a second connection confirmation detection point in a control and guiding circuit of the first charging socket; and determining a gun mounting status of the first charging gun and a gun mounting status of the first charging socket based on the first voltage value, the second voltage value, the third voltage value, and the fourth voltage value.

According to the method provided in this embodiment of this application, in addition to the obtained voltage value at the first connection confirmation detection point on the first charging gun side and the obtained voltage value at the second connection confirmation detection point on the first charging socket side, the voltage value at the second connection confirmation detection point on the first charging gun side and the voltage value at the first connection confirmation detection point on the first charging socket side are further newly added to determine the gun mounting status of the first charging gun and the gun mounting status of the first charging socket.

It may be understood that in the conventional technology, the charging device determines the gun mounting status of the first charging socket and the gun mounting status of the first charging gun by using the voltage value at the first connection confirmation detection point on the first charging gun side and the voltage value at the second connection confirmation detection point on the first charging socket side. It is assumed that the gun mounting status of the first charging socket and the gun mounting status of the first charging gun each are represented by using a vector. In this case, in the conventional technology, two dimensions are included during detection by the charging device, for example, the two dimensions are represented by using (the voltage value at the first connection confirmation detection point of the first charging gun and the voltage value at the second connection confirmation detection point of the first charging socket). However, in this solution, four dimensions are included during detection by the charging device, for example, the four dimensions are represented by using (the voltage value at the first connection confirmation detection point of the first charging gun, the voltage value at the second connection confirmation detection point of the first charging gun, the voltage value at the first connection confirmation detection point of the first charging socket, and the voltage value at the second connection confirmation detection point of the first charging socket).

It may be further understood that in this embodiment, voltage values in four dimensions are used to determine the gun mounting status of the first charging gun and the gun mounting status of the first charging socket. Therefore, even if the voltage value at the first connection confirmation detection point of the first charging gun is the same as the voltage value at the second connection confirmation detection point of the first charging socket, provided that the voltage values at the second connection confirmation detection point of the first charging gun is different at the first connection confirmation detection point of the first charging socket, a case in which the voltage value at the first connection confirmation detection point of the first charging gun is the same as the voltage value at the second connection confirmation detection point of the first charging socket but actual gun mounting statuses of the first charging gun or actual gun mounting statuses of the first charging socket are different can be identified, thereby improving detection accuracy.

With reference to the first aspect, in a possible implementation, the first charging gun is a direct-current charging gun, and the first charging socket is a direct-current charging socket.

With reference to the first aspect, in a possible implementation, the determining a gun mounting status of the first charging gun based on the first voltage value and the second voltage value includes: when the first voltage value is 4 volts, the second voltage value is 6 volts, the third voltage value is 4 volts, and the fourth voltage value is 6 volts, determining that the first charging gun is plugged into the first charging socket and a mechanical lock on the first charging gun is in a released state.

In this implementation, if the first voltage value measured by the charging device is 4 volts (V), the second voltage value is 6 V, the third voltage value is 4 V, and the fourth voltage value is 6 V, the charging device can determine that the first charging gun is plugged into the first charging socket and the mechanical lock on the first charging gun is released.

With reference to the first aspect, in a possible implementation, the determining a gun mounting status of the first charging gun and a gun mounting status of the first charging socket based on the first voltage value, the second voltage value, the third voltage value, and the fourth voltage value further includes: when the first voltage value is 6 volts, the second voltage value is 6 volts, the third voltage value is 6 volts, and the fourth voltage value is 6 volts, determining that the first charging gun is plugged into the first charging socket and the mechanical lock on the first charging gun is in a pressed state.

In this implementation, if the first voltage value measured by the charging device is 6 V, the second voltage value is 6 V, the third voltage value is 6 V, and the fourth voltage value is 6 V, the charging device can determine that the first charging gun is plugged into the first charging socket and the mechanical lock on the first charging gun is in a pressed state.

With reference to the first aspect, in a possible implementation, the determining a gun mounting status of the first charging gun and a gun mounting status of the first charging socket based on the first voltage value, the second voltage value, the third voltage value, and the fourth voltage value further includes: when the first voltage value is 12 volts, the second voltage value is 0 volts, the third voltage value is 0 volts, and the fourth voltage value is 12 volts, determining that the first charging gun leaves the first charging socket and the mechanical lock on the first charging gun is in a pressed state.

In this implementation, if the first voltage value measured by the charging device is 12 V, the second voltage value is 0 V, the third voltage value is 0 V, and the fourth voltage value is 12 V, the charging device can determine that the first charging gun leaves the first charging socket and the mechanical lock on the first charging gun is in a pressed state.

With reference to the first aspect, in a possible implementation, the determining a gun mounting status of the first charging gun and a gun mounting status of the first charging socket based on the first voltage value, the second voltage value, the third voltage value, and the fourth voltage value further includes: when the first voltage value is 6 volts, the second voltage value is 0 volts, the third voltage value is 0 volts, and the fourth voltage value is 12 volts, determining that the first charging gun leaves the first charging socket and the mechanical lock on the first charging gun is in a released state.

In this implementation, if the first voltage value measured by the charging device is 6 V, the second voltage value is 0 V, the third voltage value is 0 V, and the fourth voltage value is 12 V, the charging device can determine that the first charging gun leaves the first charging socket and the mechanical lock on the first charging gun is in a released state.

With reference to the first aspect, in a possible implementation, the determining a gun mounting status of the first charging gun and a gun mounting status of the first charging socket based on the first voltage value, the second voltage value, the third voltage value, and the fourth voltage value further includes: when the first voltage value is 12 volts, the second voltage value is 0 volts, the third voltage value is 6 volts, and the fourth voltage value is 6 volts, determining that the first charging gun leaves the first charging socket and the mechanical lock on the first charging gun is in a pressed state, that a second charging gun is plugged into the first charging socket and a mechanical lock on the second charging gun is in a pressed state, and that the second charging gun is a charging gun of another power supply device.

In this implementation, if the first voltage value measured by the charging device is 12 V, the second voltage value is 0 V, the third voltage value is 6 V, and the fourth voltage value is 6 V, the charging device can determine that the first charging gun leaves the first charging socket and the mechanical lock on the first charging gun is in a pressed state, that the second charging gun is plugged into the first charging socket and the mechanical lock on the second charging gun is in a pressed state, and that the second charging gun is a charging gun of another power supply device.

With reference to the first aspect, in a possible implementation, the determining a gun mounting status of the first charging gun and a gun mounting status of the first charging socket based on the first voltage value, the second voltage value, the third voltage value, and the fourth voltage value further includes: when the first voltage value is 12 volts, the second voltage value is 0 volts, the third voltage value is 4 volts, and the fourth voltage value is 6 volts, determining that the first charging gun leaves the first charging socket and the mechanical lock on the first charging gun is in a pressed state, and that the second charging gun is plugged into the first charging socket and the mechanical lock on the second charging gun is in a released state.

In this implementation, if the first voltage value measured by the charging device is 12 V, the second voltage value is 0 V, the third voltage value is 4 V, and the fourth voltage value is 6 V, the charging device can determine that the first charging gun leaves the first charging socket and the mechanical lock on the first charging gun is in a pressed state, and that the second charging gun is plugged into the first charging socket and the mechanical lock on the second charging gun is in a released state.

With reference to the first aspect, in a possible implementation, the determining a gun mounting status of the first charging gun and a gun mounting status of the first charging socket based on the first voltage value, the second voltage value, the third voltage value, and the fourth voltage value further includes: when the first voltage value is 6 volts, the second voltage value is not 0 volts, the third voltage value is 4 volts, and the fourth voltage value is 6 volts, determining that the first charging gun is plugged into a second charging socket and the mechanical lock on the first charging gun is in a pressed state, that the second charging gun is plugged into the first charging socket and the second charging gun is in a released state, and that the second charging socket is a charging socket of another device that needs to be charged.

In this implementation, if the first voltage value measured by the charging device is 6 V, the second voltage value is not 0 V, the third voltage value is 4 V, and the fourth voltage value is 6 V, the charging device can determine that the first charging gun is plugged into the second charging socket and the mechanical lock on the first charging gun is in a pressed state, that the second charging gun is plugged into the first charging socket and the second charging gun is in a released state, and that the second charging socket is a charging socket of another device that needs to be charged.

With reference to the first aspect, in a possible implementation, the determining a gun mounting status of the first charging gun and a gun mounting status of the first charging socket based on the first voltage value, the second voltage value, the third voltage value, and the fourth voltage value further includes: when the first voltage value is 6 volts, the second voltage value is 0 volts, the third voltage value is 6 volts, and the fourth voltage value is 6 volts, determining that the first charging gun leaves the first charging socket and the mechanical lock on the first charging gun is in a released state, and that the second charging gun is plugged into the first charging socket and the mechanical lock on the second charging gun is in a pressed state.

In this implementation, if the first voltage value measured by the charging device is 6 volts, the second voltage value is 0 volts, the third voltage value is 6 volts, and the fourth voltage value is 6 volts, the charging device can determine that the first charging gun leaves the first charging socket and the mechanical lock on the first charging gun is in a released state, and that the second charging gun is plugged into the first charging socket and the mechanical lock on the second charging gun is in a pressed state.

With reference to the first aspect, in a possible implementation, the determining a gun mounting status of the first charging gun and a gun mounting status of the first charging socket based on the first voltage value, the second voltage value, the third voltage value, and the fourth voltage value further includes: when the first voltage value is 6 volts, the second voltage value is 0 volts, the third voltage value is 4 volts, and the fourth voltage value is 6 volts, determining that the first charging gun leaves the first charging socket and the mechanical lock on the first charging gun is in a released state, and that the second charging gun is plugged into the first charging socket and the mechanical lock on the second charging gun is in a released state.

In this implementation, if the first voltage value measured by the charging device is 6 volts, the second voltage value is 0 volts, the third voltage value is 4 volts, and the fourth voltage value is 6 volts, the charging device can determine that the first charging gun leaves the first charging socket and the mechanical lock on the first charging gun is in a released state, and that the second charging gun is plugged into the first charging socket and the mechanical lock on the second charging gun is in a released state.

With reference to the first aspect, in a possible implementation, the determining a gun mounting status of the first charging gun and a gun mounting status of the first charging socket based on the first voltage value, the second voltage value, the third voltage value, and the fourth voltage value includes: when the first voltage value is 6 volts, the second voltage value is not 0 volts, the third voltage value is 0 volts, and the fourth voltage value is 12 volts, determining that the first charging gun is plugged into the second charging socket and the first mechanical lock is in a pressed state, and that no charging gun is plugged into the first charging socket.

With reference to the first aspect, in a possible implementation, the determining a gun mounting status of the first charging gun and a gun mounting status of the first charging socket based on the first voltage value, the second voltage value, the third voltage value, and the fourth voltage value further includes: when the first voltage value is 4 volts, the second voltage value is not 0 volts, the third voltage value is 0 volts, and the fourth voltage value is 12 volts, determining that the first charging gun is plugged into the second charging socket and the mechanical lock on the first charging gun is in a released state, and that no charging gun is plugged into the first charging socket.

With reference to the first aspect, in a possible implementation, the determining a gun mounting status of the first charging gun and a gun mounting status of the first charging socket based on the first voltage value, the second voltage value, the third voltage value, and the fourth voltage value further includes: when the first voltage value is 4 volts, the second voltage value is not 0 volts, the third voltage value is 6 volts, and the fourth voltage value is 6 volts, determining that the first charging gun is plugged into the second charging socket and the mechanical lock on the first charging gun is in a released state, and that the second charging gun is plugged into the first charging socket and the mechanical lock on the second charging gun is in a pressed state.

With reference to the first aspect, in a possible implementation, the determining a gun mounting status of the first charging gun and a gun mounting status of the first charging socket based on the first voltage value, the second voltage value, the third voltage value, and the fourth voltage value further includes: when the first voltage value is 4 volts, the second voltage value is not 0 volts, the third voltage value is 4 volts, and the fourth voltage value is 6 volts, determining that the first charging gun is plugged into the second charging socket and the mechanical lock on the first charging gun is in a released state, and that the second charging gun is plugged into the first charging socket and the mechanical lock on the second charging gun is in a released state.

With reference to the first aspect, in a possible implementation, the charging device includes a first controller, the control and guiding circuit of the first charging gun includes a resistor R3, the control and guiding circuit of the first charging socket includes a resistor R4, the second connection confirmation detection point of the first charging gun is connected to the resistor R3 and the first controller, and the first connection confirmation detection point of the first charging socket is connected to the resistor R4 and the first controller.

With reference to the first aspect, in a possible implementation, the charging device is a mobile charging device.

According to a second aspect, an embodiment of this application provides an apparatus for detecting a gun mounting status. The apparatus includes a module configured to perform the method according to any one of the first aspect or the possible implementations of the first aspect.

According to a third aspect, this application provides an apparatus for detecting a gun mounting status, including a memory and a processor. The memory is configured to store program instructions, and the processor is configured to invoke the program instructions in the memory to perform the method according to any one of the first aspect or the possible implementations of the first aspect.

In some implementations, the apparatus may be a chip. In this implementation, optionally, the apparatus may further include a communication interface, configured to communicate with another apparatus or device.

According to a fourth aspect, this application provides a computer-readable medium. The computer-readable medium stores program code used to be executed by a computer, and the program code includes instructions used to perform the method according to any one of the first aspect or the possible implementations of the first aspect.

According to a fifth aspect, this application provides a computer program product. The computer program product includes computer program code. When the computer program code is run on a computer, the computer is enabled to implement the method according to any one of the first aspect or the possible implementations of the first aspect.

### BRIEF DESCRIPTION OF DRAWINGS

FIG. 1 is a schematic diagram of structures of a charging gun and a charging socket according to this application;
FIG. 2 is a schematic diagram of a direct-current charging control and guiding circuit according to this application;
FIG. 3 is a schematic diagram of plugging statuses of a fast charging gun and a fast charging socket according to an embodiment of this application;
FIG. 4 is a schematic diagram of plugging statuses of a fast charging gun and a fast charging socket according to another embodiment of this application;
FIG. 5 is a schematic flowchart of a detection method according to an embodiment of this application;
FIG. 6 is a schematic diagram of a charging control and guiding circuit according to an embodiment of this application;
FIG. 7A and FIG. 7B are a schematic diagram of a structure of a relationship between a voltage and a status of a mobile charging pile according to an embodiment of this application;
FIG. 8 is a schematic diagram of a structure of a detection apparatus according to an embodiment of this application; and
FIG. 9 is a schematic diagram of a structure of a detection apparatus according to another embodiment of this application.

### DESCRIPTION OF EMBODIMENTS

With the increasing consumption of conventional energy and pollution problems, global promotion and application of new energy are being promoted. As an application form of new energy, electric vehicles are widely used in increasingly more countries and regions. Charging piles, as charging devices that provide power endurance to the electric vehicle, also appear in a large quantity in people's field of view.

Charging devices may be classified into a direct-current charging device and an alternating-current charging device based on a charging type. The alternating-current charging device provides power input to an in-vehicle charger of an electric vehicle. Because power of the in-vehicle charger is usually not very large, fast charging cannot be well implemented. The direct-current charging device (or referred to as a non-in-vehicle charger) is a device that is installed outside an electric vehicle, is connected to an alternating-current power grid, and directly outputs an adjustable direct current to an in-vehicle battery for charging. A voltage and a current that are output by the direct-current charging device have a large adjustment range, and power is large. Therefore, a fast charging requirement can be met.

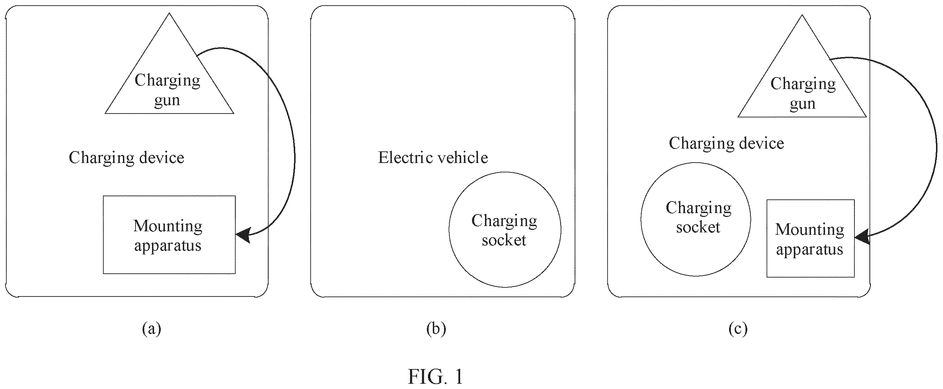

Currently, charging devices that charge an electric vehicle may be mainly classified into the following types: A first type includes only a charging gun and a mounting apparatus that stores the charging gun (as shown in (a) in FIG. 1), and the electric vehicle includes only a charging socket (as shown in (b) in FIG. 1). A second type includes both a charging gun and a charging socket, but the two are separately deployed in hardware, and an additional mounting apparatus or an additional storage port is designed for the charging gun for storage (as shown in (c) in FIG. 1).

The charging gun may be mounted into the charging socket of the electric vehicle or a charging socket of another device that needs to be charged, to charge the electric vehicle or the another device that needs to be charged. A charging gun of another power supply device may be plugged into the charging socket of the charging device, to charge the charging device.

It is noted herein that in the embodiments of this application, the direct-current charging gun is also referred to as a fast charging gun, and the direct-current charging socket is also referred to as a fast charging socket. It is further noted herein that the charging device in the embodiments of this application may alternatively include more parts, for example, a vehicle body, a high-voltage power battery, a low-voltage battery, an alternating-current charging gun, an alternating-current charging socket, a direct-current charging gun, a direct-current charging socket, and a charging controller. This is not limited in the embodiments of this application.

It may be understood that, if an electric vehicle or another device needs to be charged, the charging gun needs to be plugged into a charging socket of a device that needs to be charged. In addition, to ensure secure charging, for whether the charging gun is plugged into the charging socket, plugging statuses of the charging socket and the charging gun need to be detected by using a charging control and guiding circuit stipulated in the national standard.

The following provides description by using a direct-current charging gun and a direct-current charging socket as an example.

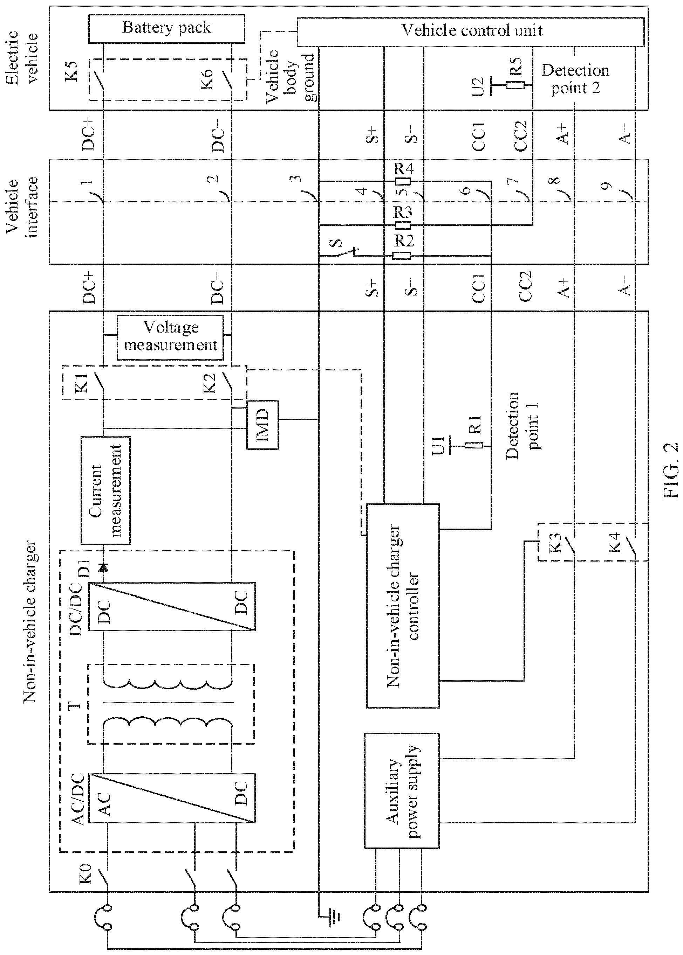

FIG. 2 is a schematic diagram of a charging control and guiding circuit according to an embodiment of this application. The circuit diagram includes three parts: a non-in-vehicle charger, a vehicle interface, and an electric vehicle. The non-in-vehicle charger part and a half part on the left of a dashed line in the vehicle interface is a control and guiding circuit of the direct-current charging gun, and a half part on the right of the dashed line in the vehicle interface and the electric vehicle part are a control and guiding circuit of the direct-current charging socket.

The vehicle interface includes nine pins in total: a positive pin of a direct-current power supply (usually represented by DC+), a negative pin of the direct-current power supply (usually represented by DC-), a protection ground pin (usually represented by PE), a high-speed bus pin for charging communication (usually represented by S+), a low-speed bus for charging communication (usually represented by S-), a charging connection confirmation pin (also referred to as a CC1), and a charging connection confirmation pin (also referred to as a CC2), a positive pin of a low-voltage auxiliary power supply (usually represented by A+), and a negative pin of the low-voltage auxiliary power supply (usually represented by A-).

As shown in FIG. 2, an entire direct-current charging control and guiding circuit includes a resistor R1, a resistor R2, a resistor R3, a resistor R4, a resistor R5, a switch S, a detection point 1, a detection point 2, a voltage U1, a voltage U2, a power supply loop contactor K1, a power supply loop contactor K2, a contactor K3, a contactor K4, a charging loop contactor K5, a charging loop contactor K6, a non-in-vehicle charger controller, and a vehicle control unit (vehicle control unit, VCU), and an auxiliary power supply.

The resistor R1 is disposed inside the non-in-vehicle charger, and has a nominal value of 1 kiloohm (in this embodiment, K uniformly represents a unit of kiloohm). The resistor R2 and the resistor R3 are disposed inside the direct-current charging gun, and both have a nominal value of 1 K. The resistor R4 is disposed in the direct-current charging socket of the electric vehicle, and has a nominal value of 1 K. The resistor R5 is disposed in the vehicle control unit of the electric vehicle, and has a nominal value of 1 K. The switch S is disposed inside the direct-current charging gun, is associated with a mechanical lock, and is in an off state by default. The voltage U1 and the voltage U2 are voltage sources of 12 volts (V). The detection point 1 is an identification signal used by the non-in-vehicle charger to detect a connection status between the direct-current charging gun and the electric vehicle, and includes three level states: 12 V, 6 V, and 4 V, where 4 V indicates that the direct-current charging gun is connected to the electric vehicle. The detection point 2 is an identification signal used by the VCU to detect a connection status between the electric vehicle and the direct-current charging gun, and includes two states: 12 V and 6 V, where 6 V indicates that the electric vehicle is connected to the direct-current charging gun.

The power supply loop contactor K1 and the power supply loop contactor K2 are respectively high-voltage positive and negative relays of the non-in-vehicle charger.

The contactor K3 and the contactor K4 are respectively positive and negative relays for low-voltage wakeup of the non-in-vehicle charger, and may output a low voltage to the VCU to wake up the VCU.

The charging loop contactor K5 and the charging loop contactor K6 are high-voltage positive and negative relays of a battery pack.

It is noted herein that a diode D1 in FIG. 2 is intended to prevent a reverse current, and may also be replaced by another circuit.

For the direct-current charging control and guiding circuit shown in FIG. 2, when the direct-current charging gun is plugged into the direct-current charging socket, a connection point 1 to a connection point 9 marked in FIG. 2 complete a circuit connection. The direct-current charging gun includes a mechanical lock. When the mechanical lock is pressed, the switch S is turned off, and the direct-current charging gun can be plugged out. When the mechanical lock is released, the switch S is turned on. If the direct-current charging gun is plugged into the direct-current charging socket in this case, the direct-current charging gun and the direct-current charging socket are locked, and the direct-current charging gun cannot be plugged out.

Based on a stipulation in the national standard "GBT 18487.1-2015 Electric Vehicle Conductive Charging System", a voltage value at the detection point 1 (that is, a voltage value at the CC1) in the control and guiding circuit of the direct-current charging gun in FIG. 2 and a voltage value at the detection point 2 (that is, a voltage value at the CC2) in the control and guiding circuit of the direct-current charging socket may be detected to determine plugging statuses of the direct-current charging gun and the direct-current charging socket. In other words, the voltage value at the CC1 is detected in the direct-current charging gun, and the voltage value at the CC2 is detected in the direct-current charging socket, to determine the plugging statuses of the direct-current charging gun and the direct-current charging socket.

The following specifically describes a method for determining the plugging statuses of the direct-current charging gun and the direct-current charging socket by detecting the voltage value at the CC1 in the control and guiding circuit of the direct-current charging gun and the voltage value at the CC2 in the control and guiding circuit of the direct-current charging socket.

Based on a hardware circuit principle, for the direct-current charging gun, there may be three types of voltages at the CC1 of the direct-current charging gun: 12 V, 6 V, and 4 V.

Specifically, when the direct-current charging gun is mounted into a mounting apparatus or stored in a dedicated storage port, the voltage at the CC1 is 6 V; when the mechanical lock on the direct-current charging gun is pressed (the switch S in the direct-current charging control and guiding circuit is turned off), the voltage at the CC1 is 12 V; when the direct-current charging gun is plugged into the direct-current charging socket, the connection point 6 completes a circuit connection, and the mechanical lock is still pressed, the voltage at the CC1 is 6 V; and when the direct-current charging gun is plugged into the direct-current charging socket, and the mechanical lock is released, the voltage at the CC1 is 4 V.

In other words, the plugging status of the direct-current charging gun may be learned by detecting the voltage at the CC1.

Similarly, based on the hardware circuit principle, for the direct-current charging socket in the electric vehicle, there may be two types of voltages at the CC2 on the direct-current charging socket side: 12 V and 6 V.

Specifically, when the direct-current charging gun is not plugged into the direct-current charging socket, that is, when the connection point 1 to the connection point 9 in FIG. 2 are disconnected, the voltage value at the CC2 is 12 V; and when the direct-current charging gun is plugged into the direct-current charging socket, and the connection point 7 completes a circuit connection, the voltage at the CC2 is 6 V.

In other words, the plugging status of the direct-current charging socket may be learned by detecting the voltage at the CC2.

It is noted herein that, for a method for detecting plugging statuses of an alternating-current charging gun and an alternating-current charging socket, refer to description in a related technology. Details are not described herein.

However, compared with a charging device including only a charging gun, a charging device including both a charging gun and a charging socket can simultaneously obtain a voltage value of the charging gun at a connection confirmation detection point and a voltage value of the charging socket at a connection confirmation detection point. In addition, there may include a plurality of different combinations of the charging gun and the charging socket of the charging device. For example, the charging gun of the charging device is plugged into the charging socket of the charging device and a mechanical lock on the charging gun of the charging device is released; or the charging gun of the charging device is plugged into a charging socket of another device that needs to be charged and the mechanical lock on the charging gun of the charging device is released, and a charging gun of another power supply device is plugged into the charging socket of the charging device. In this case, for the plurality of combinations of the charging gun and the charging socket of the charging device, if a method in the conventional technology is used, to be specific, the charging device detects one voltage value in the charging gun and one voltage value in the charging socket, the following case may occur: actual plugging statuses of the charging gun and the charging socket are different but the measured voltage values are the same.

The following uses an example in which the charging gun of the charging device is a direct-current charging gun and the charging socket is a direct-current charging socket.

In an example, in a scenario, when the direct-current charging gun of the charging device is plugged into the direct-current charging socket of the charging device, and a connection point 1 to a connection point 9 are in a connected state, a voltage value that is at a CC1 of the direct-current charging gun and that is detected by a controller of the charging device is 4 V, and a voltage value at a CC2 on the direct-current charging socket side is 6 V. In another scenario, when the direct-current charging gun of the charging device is plugged into a direct-current charging socket of another device that needs to be charged, the connection point 1 to the connection point 9 of the direct-current charging gun of the charging device are in a connected state, a direct-current charging gun of another power supply device is plugged into the direct-current charging socket of the charging device, and the connection point 1 to the connection point 9 of the direct-current fast charging socket of the charging device are in a connected state, a voltage value that is at the CC1 of the direct-current charging gun and that is detected by the controller of the charging device is still 4 V, and a voltage value at the CC2 on the direct-current charging socket side is still 6 V.

To be specific, if the controller of the charging device that includes both the charging gun and the charging socket uses only the fact that the voltage value at the CC1 of the direct-current charging gun is 4 V and the voltage value at the CC2 on the direct-current charging socket side is 6 V, the controller cannot accurately identify actual plugging statuses of the direct-current charging gun and the direct-current charging socket.

In another example, in a scenario, when the direct-current charging gun of the charging device is plugged into the direct-current charging socket of the charging device, and a mechanical lock on the direct-current charging gun is pressed to prepare to plug out the direct-current charging gun, a voltage value that is at the CC1 of the direct-current charging gun and that is detected by the controller of the charging device is 6 V, and a voltage value at the CC2 on the direct-current charging socket side is 6 V. In another scenario, when the direct-current charging gun of the charging device is plugged out and the mechanical lock is released, and a direct-current charging gun of another power supply device is plugged into the direct-current charging socket of the charging device, a voltage value that is at the CC1 of the direct-current charging gun and that is detected by the controller of the charging device is still 6 V, and a voltage value at the CC2 on the direct-current charging socket side is still 6 V. In still another scenario, the direct-current charging gun of the charging device is plugged into a direct-current charging socket of another device that needs to be charged, the mechanical lock on the direct-current charging gun of the charging device is pressed, and a direct-current charging gun of another power supply device is plugged into the direct-current charging socket of the charging device. In this case, a voltage value that is at the CC1 of the direct-current charging gun and that is detected by the controller of the charging device is still 6 V, and a voltage value at the CC2 on the direct-current charging socket side is still 6 V.

In other words, if the controller of the charging device uses only the fact that the voltage value at the CC1 of the direct-current charging gun is 6 V and the voltage value at the CC2 on the direct-current charging socket side is 6 V, the controller cannot accurately identify actual plugging statuses of the direct-current charging gun and the direct-current charging socket.

In still another example, in a scenario, when the direct-current charging gun of the charging device has left the direct-current charging socket of the charging device, the mechanical lock on the direct-current charging gun of the charging device is released, and the direct-current charging socket of the charging device is suspended, a voltage value that is at the CC1 of the direct-current charging gun and that is detected by the controller of the charging device is 6 V, and a voltage value at the CC2 on the direct-current charging socket side is 12 V. In another scenario, when the direct-current charging gun of the charging device is plugged into a direct-current charging socket of another device that needs to be charged, and the mechanical lock on the direct-current charging gun is pressed and not released, a voltage value that is at the CC1 of the direct-current charging gun and that is detected by the controller of the charging device is still 6 V, and a voltage value at the CC2 on the direct-current charging socket side is still 12 V.

In other words, if the controller of the charging device uses only the fact that the voltage value at the CC1 of the direct-current charging gun is 6 V and the voltage value at the CC2 on the direct-current charging socket side is 12 V, the controller cannot accurately identify actual plugging statuses of the direct-current charging gun and the direct-current charging socket.

In other words, in the foregoing three examples, the controller of the charging device cannot accurately identify actual plugging statuses of the direct-current charging socket and the direct-current charging gun by using only the voltage value at the CC1 of the direct-current charging gun and the voltage value at the CC2 on the direct-current charging socket side. This brings a problem to low-power-consumption sleep and wakeup of the charging device.

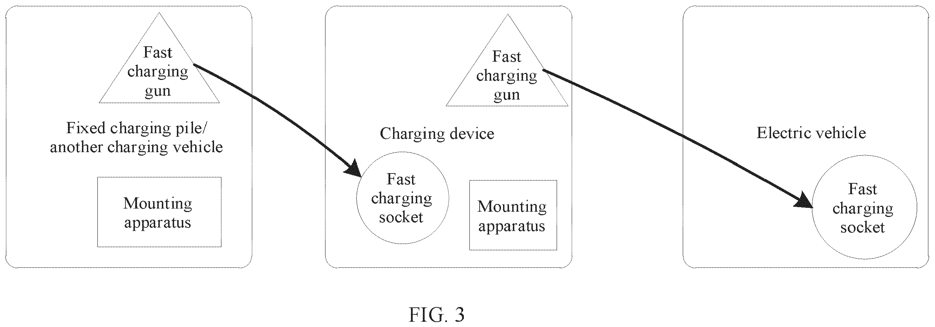

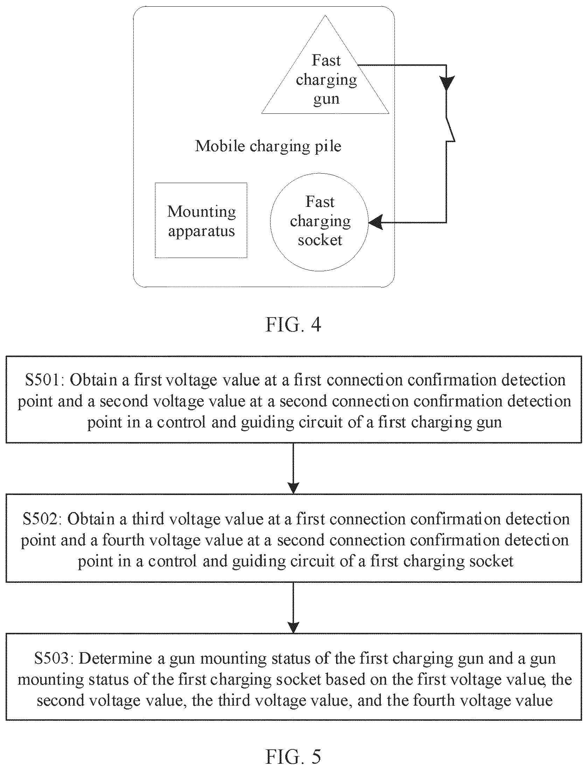

For example, as shown in FIG. 3, when the direct-current charging gun of the charging device is plugged into a direct-current charging socket of a charged vehicle, charging is completed, and the charging device enters a low-power-consumption sleep working state, if a direct-current charging gun of another charging device (for example, a fixed charging pile or another charging vehicle) is plugged into the direct-current charging socket of the charging device in this case, the charging device is woken up. After the charging device is woken up, the controller detects a voltage value at the CC1 of the direct-current charging gun and a voltage value at the CC2 on the direct-current charging socket side, and mistakenly considers that the direct-current charging gun of the charging device is plugged into the direct-current charging socket of the charging device in this case (as shown in FIG. 4), and that the charging device is in a movable state. Further, if the charging device receives an order in this case, the charging device moves, and disconnects the direct-current charging gun of the charging device from a direct-current charging gun of another charging device. As a result, functions such as low-power-consumption sleep and wakeup cannot be supported.

In view of this, the embodiments of this application provide a new method for detecting statuses of a charging gun and a charging socket. In the method, a charging device obtains two voltage values in a first charging gun, and also obtains two voltage values in a first charging socket, that is, obtains four voltage values in total, and then determines plugging statuses of the first charging gun and the first charging socket based on the four voltage values.

FIG. 5 is a schematic flowchart of a method for detecting statuses of a charging gun and a charging socket according to an embodiment of this application. As shown in FIG. 5, the method in this embodiment of this application may include S501, S502, and S503. The method is performed by a charging device, and the charging device includes a first charging gun and a first charging socket.

S501: Obtain a first voltage value at a first connection confirmation detection point and a second voltage value at a second connection confirmation detection point in a control and guiding circuit of the first charging gun.

In this embodiment, the charging device separately obtains the first voltage value and the second voltage value. The first voltage value represents a current voltage at the first connection confirmation detection point in the control and guiding circuit of the first charging gun of the charging device, and the second voltage value represents a current voltage at the second connection confirmation detection point in the control and guiding circuit of the first charging gun of the charging device.

For example, if the first charging gun is a direct-current charging gun, the first connection confirmation detection point may be a CC1 in a direct-current control and guiding circuit on the direct-current charging gun side, and the second connection confirmation detection point may be a CC2 in the direct-current control and guiding circuit on the direct-current charging gun side. In this case, the first voltage value is a voltage value at the CC1 on the direct-current charging gun side, and the second voltage value is a voltage value at the CC2 on the direct-current charging gun side.

In other words, in this embodiment, both the voltage at the first connection confirmation detection point and the voltage at the second connection confirmation detection point of the first charging gun are obtained of the first charging gun, that is, two voltage values of the first charging gun are obtained.

It is noted herein that an implementation in which the charging device obtains the voltages at the first connection confirmation detection point and the second connection confirmation detection point of the first charging gun is not limited in this embodiment of this application.

For example, the first charging gun is a direct-current charging gun. For the current voltage at the first connection confirmation detection point (namely, the CC1) of the first charging gun, in an implementation, because in the current control and guiding circuit of the direct-current charging gun, the CC1 is connected to a non-in-vehicle charger controller of the charging device by using a wire, the voltage at the CC1 may be obtained by using the non-in-vehicle charger controller.

For the current voltage at the second connection confirmation detection point of the first charging gun, the charging device may directly or indirectly obtain the current voltage at the second connection confirmation detection point in the control and guiding circuit of the first charging gun.

For example, the first charging gun is a direct-current charging gun. In an implementation, the current voltage at the connection confirmation detection point (namely, the CC2) in the control and guiding circuit of the first charging gun may be measured by using a voltmeter, and then the measured voltage is sent to the non-in-vehicle charger controller of the first charging gun, so that the charging device can obtain the current voltage at the CC2 of the first charging gun (that is, the charging device indirectly obtains the current voltage). However, in another implementation, the current CC2 of the first charging gun may be connected to the non-in-vehicle charger controller, so that the non-in-vehicle charger controller can directly obtain the current voltage at the CC2 of the first charging gun (that is, the charging device directly obtains the current voltage).

For specific descriptions of the non-in-vehicle charger controller and functions that can be implemented by the non-in-vehicle charger controller, refer to descriptions in a related technology. Details are not described herein.

S502: Obtain a third voltage value at a first connection confirmation detection point and a fourth voltage value at a second connection confirmation detection point in a control and guiding circuit of the first charging socket.

In this embodiment, the charging device separately obtains the third voltage value and the fourth voltage value. The third voltage value represents a current voltage at the first connection confirmation detection point in the control and guiding circuit of the first charging socket of the charging device, and the fourth output voltage value represents a current voltage at the second connection confirmation detection point in the control and guiding circuit of the first charging socket of the charging device.

For example, if the first charging gun is a direct-current charging socket, the first connection confirmation detection point may be a CC1 in a direct-current control and guiding circuit of the direct-current charging gun socket, and the second connection confirmation detection point may be a CC2 in the direct-current control and guiding circuit on the direct-current charging socket side. In this case, the third voltage value is a voltage value at the CC1 on the direct-current charging socket side, and the second voltage value is a voltage value at the CC2 on the direct-current charging socket side.

In other words, in this embodiment, both the voltage at the first connection confirmation detection point and the voltage at the second connection confirmation detection point on the first charging socket side are obtained in the first charging socket, that is, two voltage values of the first charging socket are obtained.

It is noted herein that an implementation in which the charging device obtains the voltages at the first connection confirmation detection point and the second connection confirmation detection point of the first charging socket is not limited in this embodiment of this application.

For example, the first charging socket is a direct-current charging socket. For the current voltage at the second connection confirmation detection point (namely, the CC2) of the first charging socket, in an implementation, because in the current control and guiding circuit of the direct-current charging socket, the CC2 is connected to a controller of the charging device by using a wire, the voltage at the CC2 may be obtained by using the controller.

For example, for the current voltage at the first connection confirmation detection point of the first charging socket, the charging device may also directly or indirectly obtain the current voltage at the first connection confirmation detection point in the control and guiding circuit of the first charging socket.

For example, the first charging gun is a direct-current charging gun. In an implementation, the current voltage at the first connection confirmation detection point (namely, the CC1) in the control and guiding circuit of the first charging socket may be measured by using a voltmeter, and then the measured voltage is sent to a controller of the first charging socket, so that the charging device can obtain the current voltage at the CC1 of the first charging socket (that is, the current voltage is indirectly obtained). In another implementation, the current CC1 of the first charging socket may be connected to the controller of the charging device, so that the controller of the charging device can directly obtain the current voltage at the CC1 of the first charging socket (that is, a the current voltage is directly obtained).

It is noted herein that for detailed descriptions of the CC1 and the CC2 in S501 and S502, refer to descriptions in the foregoing embodiment of this application or in a related technology. Details are not described herein.

S503: Determine a gun mounting status of the first charging gun and a gun mounting status of the first charging socket based on the first voltage value, the second voltage value, the third voltage value, and the fourth voltage value.

In this embodiment, the first charging gun of the charging device includes the following gun mounting states:
the first charging gun is mounted into a mounting apparatus or stored in a dedicated storage port;
the first charging gun is not plugged into a charging socket, and a mechanical lock on the first charging gun is pressed;
the first charging gun is plugged into the first charging socket of the charging device, and the mechanical lock on the first charging gun is pressed;
the first charging gun is plugged into the first charging socket of the charging device, and the mechanical lock on the first charging gun is released;
the first charging gun is plugged into a charging socket of another device that needs to be charged, and the mechanical lock on the first charging gun is pressed; and
the first charging gun is plugged into the charging socket of the charging device, and the mechanical lock on the first charging gun is released.

In this embodiment, the first charging socket of the charging device includes the following gun mounting states:
no charging gun is plugged into the first charging socket;
the first charging gun is plugged into the first charging socket; and
a charging gun of another power supply device (for example, a fixed charging pile or another mobile charging vehicle) is plugged into the first charging socket.

It is noted herein that, because a gun mounting status is essentially a plugging status of the first charging gun and that of the first charging socket, in this application, determining the gun mounting status of the first charging gun is also referred to as determining the plugging status of the first charging gun, and determining the gun mounting status of the first charging socket is also referred to as determining the plugging status of the first charging socket.

It may be understood that the first charging gun and the first charging socket may have a plurality of different combinations. For example, the first charging gun is plugged into the first charging socket and the mechanical lock on the first charging gun is released; or the first charging gun is plugged into a charging socket of another device that needs to be charged and the mechanical lock on the first charging gun is released, and a charging gun of another power supply device is plugged into the first charging socket. In this case, for the plurality of combinations of the first charging gun and the first charging socket of the charging device, if a method in the conventional technology is used, to be specific, the charging device detects one voltage value in the first charging gun and one voltage value of the first charging socket, the following case may occur: actual plugging statuses of the first charging gun and the first charging socket are different but the measured voltage values are the same.

For example, when the first charging gun is a direct-current charging socket and the first charging gun is a direct-current charging socket, if the first charging gun is plugged into the first charging socket and the mechanical lock on the first charging gun is released, the charging device detects that the voltage at the CC1 on the first charging gun side is 4 V and the voltage at the CC2 on the first charging socket side is 6 V. Similarly, if the first charging gun is plugged into a charging socket of another device that needs to be charged and the mechanical lock on the first charging gun is released, the charging device detects that the voltage at the CC1 on the first charging gun side is still 4 V. In this case, when a charging gun of another power supply device (for example, a fixed charging pile or another mobile charging vehicle) is plugged into the first charging socket, the charging device also detects that the voltage at the CC2 on the first charging socket side is 6 V.

In other words, through only the voltage at the CC1 on the first charging gun side and the voltage at the CC2 on the first charging socket side, the charging device cannot determine whether the first charging gun is plugged into the first charging socket or a charging socket of another device that needs to be charged, or cannot determine whether the first charging gun or a charging gun of another power supply device is plugged into the first charging socket.

In view of this, in this embodiment, when detecting plugging statuses of the first charging gun and the first charging socket, the charging device obtains two voltage values in the first charging gun and two values in the first charging socket. To be specific, in addition to the obtained voltage value at the first connection confirmation detection point on the first charging gun side and the obtained voltage value at the second connection confirmation detection point on the first charging socket side, the voltage value at the second connection confirmation detection point on the first charging gun side and the voltage value at the first connection confirmation detection point on the first charging socket side are further newly added, to distinguish between different states of the first charging gun and the first charging socket.

In other words, in the conventional technology, the charging device determines the plugging statuses of the first charging socket and the first charging gun by using (the voltage value at the first connection confirmation detection point on the first charging gun side and the voltage value at the second connection confirmation detection point on the first charging socket side). However, in this embodiment, the charging device identifies the plugging status of the first charging gun and the plugging status of the first charging socket by using four voltage values (the voltage value at the first connection confirmation detection point on the first charging gun side, the voltage value at the second connection confirmation detection point on the first charging gun side, the voltage value at the first connection confirmation detection point on the first charging socket side, and the voltage value at the second connection confirmation detection point on the first charging socket side).

It may be understood that, assuming that each state is represented by using one vector, in the conventional technology, each state includes two dimensions, for example, the two dimensions are represented by using (the voltage value at the first connection confirmation detection point of the first charging gun and the voltage value at the second connection confirmation detection point of the first charging socket). In this solution, each state includes four dimensions, for example, the four dimensions are represented by using (the voltage value at the first connection confirmation detection point of the first charging gun, the voltage value at the second connection confirmation detection point of the first charging gun, the voltage value at the first connection confirmation detection point of the first charging socket, and the voltage value at the second connection confirmation detection point of the first charging socket).

It may be further understood that in this embodiment, voltage values in four dimensions are used to determine the plugging status of the first charging gun and the plugging status of the first charging socket. Therefore, even if the voltage at the first connection confirmation detection point of the first charging gun is the same as the voltage value at the second connection confirmation detection point of the first charging socket, provided that the voltage value at the second connection confirmation detection point of the first charging gun is different from any voltage value at the first connection confirmation detection point of the first charging socket, a probability of identifying a case in which the voltage at the first connection confirmation detection point of the first charging gun is the same as the voltage value at the second connection confirmation detection point of the first charging socket but corresponding plugging statuses of the first charging gun and corresponding plugging statuses of the first charging socket are different can be improved. In other words, it may be considered that the two newly added voltage values have a function of identifying a case in which voltage values are the same but statuses are different.

In the status detection method provided in this embodiment, in addition to the obtained voltage value at the first connection confirmation detection point on the first charging gun side and the obtained voltage value at the second connection confirmation detection point on the first charging socket side, the voltage value at the second connection confirmation detection point on the first charging gun side and the voltage value at the first connection confirmation detection point on the first charging socket side are further newly added. Compared with the conventional technology in which only two voltage values are detected, the charging device in this embodiment can improve accuracy of detecting the plugging status of the first charging gun and the plugging status of the first charging socket.

It is noted herein that the foregoing merely describes the following: the method in this application is applied to detection of statuses of a direct-current charging gun and a direct-current charging socket. However, the method may also be used for detection of an alternating-current charging gun and an alternating-current charging socket. To be specific, for the alternating-current charging gun and the alternating-current charging socket, in the conventional technology, two voltage values are used to detect plugging statuses of the alternating-current charging gun and the alternating-current charging socket. When a case in which voltage values are the same but the plugging statuses of the alternating-current charging gun and the alternating-current charging socket are different cannot be correctly identified, if a method of detecting four voltage values is used to identify the foregoing case in which the voltage values are the same but actual plugging statuses of the alternating-current charging gun and the alternating-current charging socket are different, this also belongs to the concept of this application.

In an optional embodiment, the first charging gun is a direct-current charging gun, and the first charging socket is a direct-current charging socket.

Further, when the first charging gun is a direct-current charging gun and the first charging socket is a direct-current charging socket, in an optional embodiment, the charging device includes a first controller, the control and guiding circuit of the first charging gun includes a resistor R3, the control and guiding circuit of the first charging socket includes a resistor R4, the second connection confirmation detection point of the first charging gun is connected to the resistor R3 and the first controller, and the first connection confirmation detection point of the first charging socket is connected to the resistor R4 and the first controller. The first controller in this embodiment may be considered as a non-in-vehicle charger controller in a non-in-vehicle charger.

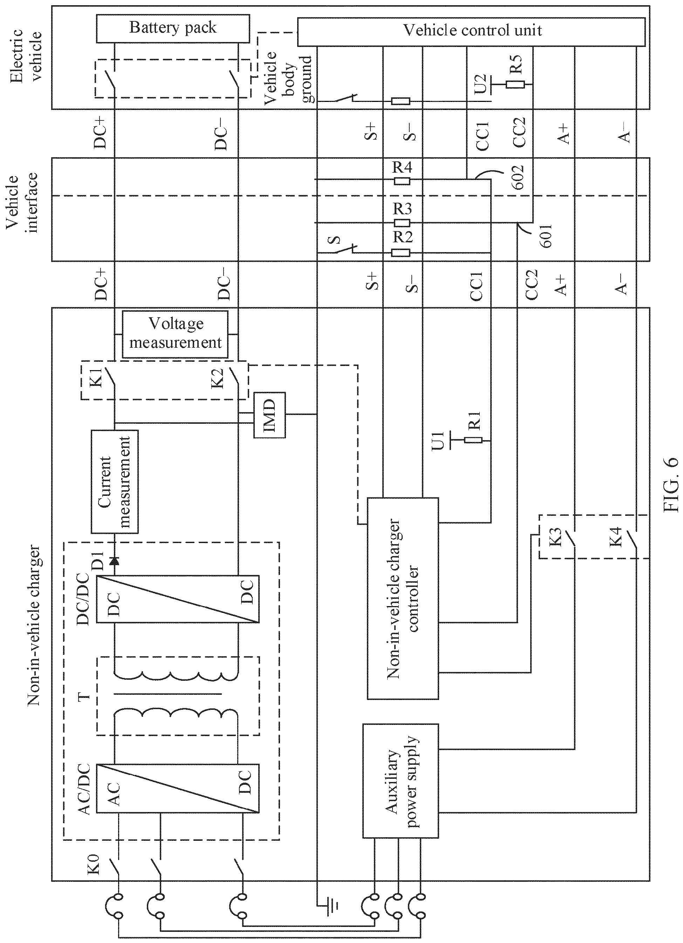

For example, FIG. 6 is a hardware circuit diagram of a connection between a non-in-vehicle charger, a vehicle interface, and an electric vehicle according to an embodiment of this application. A difference between FIG. 6 and FIG. 2 lies in the following: In the direct-current charging control and guiding circuit of the first charging gun, a corresponding circuit at the CC2 of the first charging gun is connected to the first controller by using a wire (as shown by a wire 601 in the non-in-vehicle charger in FIG. 6), to add detection of the voltage at the CC2 of the first charging gun. In the direct-current charging control and guiding circuit of the first charging socket, a corresponding circuit at the CC1 of the first charging socket is connected to the controller by using a wire (as shown by a wire 602 in the non-in-vehicle charger in FIG. 6), to add detection of the voltage at the CC1 of the first charging socket. In other words, the first controller simultaneously detects, in the first charging gun, the voltage values at the CC1 and the CC2 on the direct-current charging gun side, and also detects, in the first charging socket, the voltage values at the CC1 and the CC2 on the direct-current charging socket side, that is, the first controller detects four voltage values in total to detect actual plugging statuses of the charging gun and the charging socket of the charging device.

In this application, two voltage detection points are newly added to a direct-current charging control and guiding hardware circuit of the direct-current charging gun and the direct-current charging socket, and two voltage values stipulated in the national standard and voltage values at the two voltage detection points newly added in this application are detected, to identify plugging statuses of the direct-current charging gun and the direct-current charging socket.

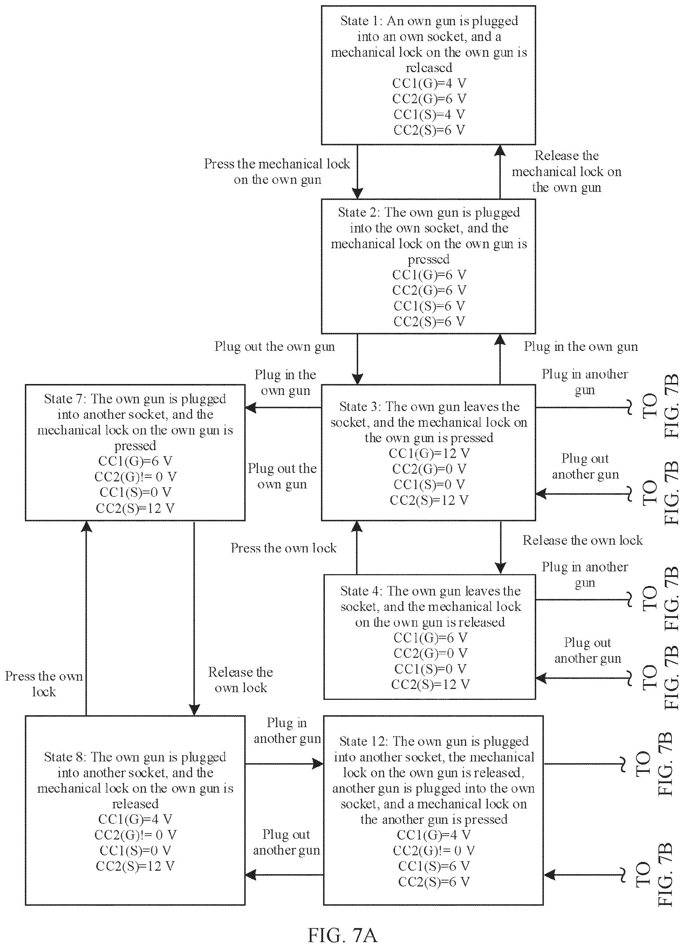

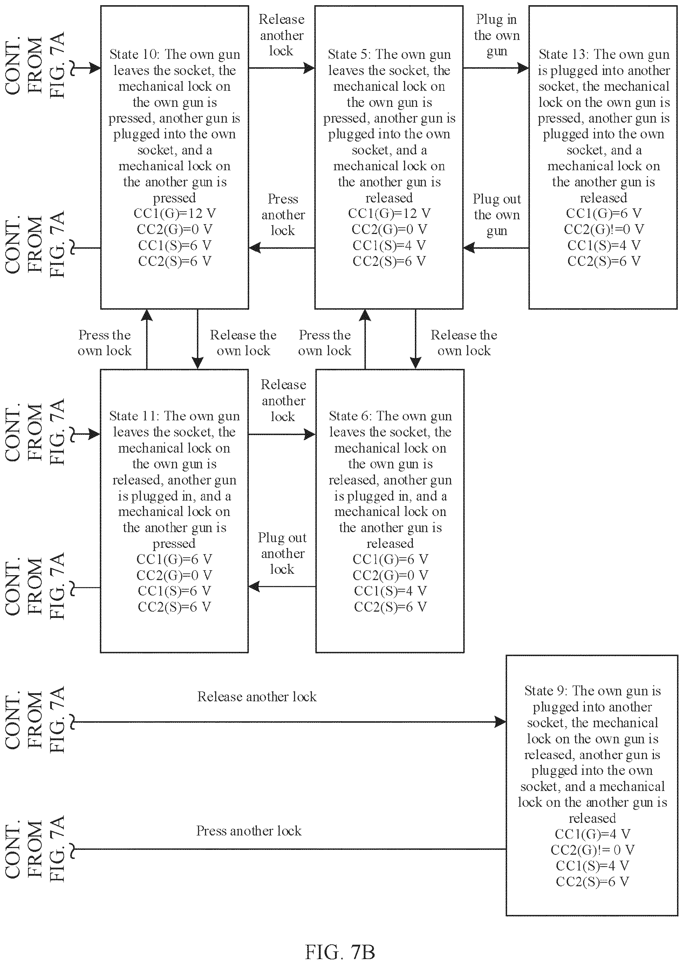

With reference to FIG. 7A and FIG. 7B, the following describes in detail a method for detecting a plugging status of a direct-current charging gun and a plugging status of a direct-current charging socket according to an embodiment of this application. In this embodiment, an example in which a charging device is a mobile charging device, a first charging gun in the mobile charging device is a direct-current charging gun, and a first charging socket is a direct-current charging socket is used for description. For ease of description, in this embodiment, the first charging gun is also referred to as a first direct-current charging gun, and the first charging socket is also referred to as a first direct-current charging socket.

FIG. 7A and FIG. 7B are a schematic diagram of structures of voltage values corresponding to a direct-current charging gun and a direct-current charging socket in different states according to an embodiment of this application.

It is noted herein that in the figure, an own gun represents the direct-current charging gun of the mobile charging device, an own socket represents the direct-current charging socket of the mobile charging device, another gun represents a direct-current charging gun of another power supply device, and another socket represents a direct-current charging socket of another device that needs to be charged. CC1(G) represents a voltage value of the first direct-current charging gun at a point CC1, that is, a first voltage value; CC2(G) represents a voltage value of the first direct-current charging gun at a CC2, that is, a second voltage value; CC1(S) represents a voltage value of the first direct-current charging socket at a CC1, that is, a third voltage value; and CC2(S) represents a voltage value of the first direct-current charging socket at a CC2, that is, a fourth voltage value.

With reference to several specific embodiments, the following describes a method for accurately detecting a plugging status of the first direct-current charging gun and a plugging status of the first direct-current charging socket in this application.

### Embodiment 1

In a first scenario, that a status of the first direct-current charging gun and a status of the first direct-current charging socket are determined based on the first voltage value, the second voltage value, the third voltage value, and the fourth voltage value includes: when the first voltage value is 4 V, the second voltage value is 6 V, the third voltage value is 4 V, and the fourth voltage value is 6 V (for example, a state 1 in FIG. 7A), determining that the first direct-current charging gun is plugged into the first direct-current charging socket and a mechanical lock on the first direct-current charging gun is in a released state.

It may be understood that, when the first direct-current charging gun is plugged into the first direct-current charging socket and the mechanical lock on the first direct-current charging gun is released, a circuit connection is completed between a left half part (an interface of the first direct-current charging gun in this embodiment) of a vehicle interface circuit and a connection point 1 to a connection point 9 in a right half part (an interface of the first direct-current charging socket in this embodiment) of the vehicle interface circuit. In this case, the voltage value at the connection confirmation detection point CC1 on the first direct-current charging gun side is equal to the voltage value at the CC1 of the first direct-current charging socket, and the voltage value at the connection confirmation detection point CC2 on the first direct-current charging gun side is equal to the voltage value at the CC2 of the first direct-current charging socket. In addition, because the voltage value at the connection confirmation detection point CC1 on the first direct-current charging gun side is equal to 4 V, and the voltage value at the CC2 of the first direct-current charging socket is equal to 6 V, both the first voltage value and the third voltage value are equal to 4 V, and both the second voltage value and the fourth voltage value are equal to 6 V.

In a second scenario, that a status of the first direct-current charging gun and a status of the first direct-current charging socket are determined based on the first voltage value, the second voltage value, the third voltage value, and the fourth voltage value includes: when the first voltage value is 4 V, the second voltage value is not 0 V, the third voltage value is 4 V, and the fourth voltage value is 6 V (for example, a state 9 in FIG. 7B), determining that the first direct-current charging gun is plugged into a second direct-current charging socket and a mechanical lock on the first direct-current charging gun is in a released state, and that a second direct-current charging gun is plugged into the first direct-current charging socket and a mechanical lock on the second direct-current charging gun is in a released state.

In this embodiment, the second direct-current charging socket represents a direct-current charging socket of another device that needs to be charged, that is, the second direct-current charging socket is not the direct-current charging socket of the mobile charging device. The second direct-current charging gun represents a direct-current charging gun of another power supply device, that is, the second direct-current charging gun is not the direct-current charging gun of the mobile charging device.

It may be understood that, when the first direct-current charging gun is plugged into the second direct-current charging socket and the mechanical lock on the first direct-current charging gun is released, a circuit connection is completed between a left half part (an interface of the first direct-current charging gun in this embodiment) of a vehicle interface circuit and a connection point 1 to a connection point 9 in a right half part (an interface of the second direct-current charging socket in this embodiment) of the vehicle interface circuit. In this case, the voltage value at the connection confirmation detection point CC1 on the first direct-current charging gun side is equal to a voltage value at a CC1 of the second direct-current charging socket, and the voltage value at the connection confirmation detection point CC2 on the first direct-current charging gun side is equal to a voltage value at a CC2 on the second direct-current charging socket. In addition, because the voltage value at the connection confirmation detection point CC1 on the first direct-current charging gun side is equal to 4 V, and the voltage value at the CC2 of the second direct-current charging socket is equal to 6 V, the first voltage value is equal to 4 V, and the second voltage value is not equal to 0 V.

When a direct-current charging gun (that is, the second direct-current charging gun) of another power supply device is plugged into the first direct-current charging socket and the mechanical lock on the second direct-current charging gun is in a released state, a circuit connection is completed between the left half part (an interface of the second direct-current charging gun in this embodiment) of the vehicle interface circuit and the connection point 1 to the connection point 9 in the right half part (an interface of the first direct-current charging socket in this embodiment) of the vehicle interface circuit. In this case, a voltage value at a connection confirmation detection point CC1 on the second direct-current charging gun side is equal to the voltage value at the connection confirmation detection point CC1 of the first direct-current charging socket, and a voltage value at a connection confirmation detection point CC2 on the second direct-current charging gun side is equal to the voltage value at the CC2 of the first direct-current charging socket. In addition, because the voltage value at the connection confirmation detection point CC1 on the second direct-current charging gun side is equal to 4 V, and the voltage value at the connection confirmation detection point CC2 of the first direct-current charging socket is equal to 6 V, the voltage value (that is, the third voltage value) at the connection confirmation detection point CC1 on the first direct-current charging socket side is equal to 4 V, and the voltage value (that is, the fourth voltage value) at the connection confirmation detection point CC2 of the first direct-current charging socket is equal to 6 V.

In a third scenario, that a status of the first direct-current charging gun and a status of the first direct-current charging socket are determined based on the first voltage value, the second voltage value, the third voltage value, and the fourth voltage value includes: when the first voltage value is 4 V, the second voltage value is not 0 V, the third voltage value is 6 V, and the fourth voltage value is 6 V (for example, a state 12 in FIG. 7A), determining that the first direct-current charging gun is plugged into a second direct-current charging socket and a mechanical lock on the first direct-current charging gun is in a released state, and that a second direct-current charging gun is plugged into the first direct-current charging socket and a mechanical lock on the second direct-current charging gun is in a pressed state.

In this embodiment, for concepts of the second direct-current charging socket and the second direct-current charging gun, refer to descriptions in the second scenario in this embodiment. Details are not described herein again.

It may be understood that, when the first direct-current charging gun is plugged into the second direct-current charging socket and the mechanical lock on the first direct-current charging gun is in a pressed state, the voltage value at the connection confirmation detection point CC1 on the first direct-current charging gun side is equal to 4 V, and the voltage value at the connection confirmation detection point CC2 on the first direct-current charging gun side is equal to a voltage value at a CC2 of the second direct-current charging socket. In addition, because the voltage value at the CC2 of the second direct-current charging socket is equal to 6 V, the first voltage value is equal to 4 V, and the second voltage value is not 0 V.

When a direct-current charging gun (that is, the second direct-current charging gun) of another power supply device is plugged into the first direct-current charging socket and the mechanical lock on the second direct-current charging gun is in a pressed state, a voltage value at a connection confirmation detection point CC1 on the second direct-current charging gun side is equal to the voltage value at the connection confirmation detection point CC1 of the first direct-current charging socket, and the voltage value at the connection confirmation detection point CC2 of the first direct-current charging socket is equal to 6 V. In addition, because the voltage value at the connection confirmation detection point CC1 on the second direct-current charging gun side is equal to 6 V, the voltage value (that is, the third voltage value) at the connection confirmation detection point CC1 on the first direct-current charging socket side is equal to 6 V, and the voltage value (that is, the fourth voltage value) at the connection confirmation detection point CC2 of the first direct-current charging socket is equal to 6 V.

In the status detection method provided in this embodiment of this application, in the three scenarios, voltage values at the connection confirmation detection point CC1 on the first direct-current charging gun side all are equal to 4 V, and voltage values at the connection confirmation detection point CC2 on the first direct-current charging socket side all are equal to 6 V. In other words, in the conventional technology, if only the voltage value at the connection confirmation detection point CC1 on the first direct-current charging gun side and the voltage value at the connection confirmation detection point CC2 on the first direct-current charging socket side are used to detect plugging statuses of the first direct-current charging gun and the first direct-current charging socket, when detecting that the first voltage value is 4 V and the fourth voltage value is 6 V, the mobile charging device cannot accurately determine a specific scenario in which the voltage values are generated. Consequently, detection is inaccurate. However, in this embodiment, in addition to the voltage value at the connection confirmation detection point CC1 on the first direct-current charging gun side and the voltage value at the connection confirmation detection point CC2 on the first direct-current charging socket side, the voltage value at the connection confirmation detection point CC2 on the first direct-current charging gun side and the voltage value at the connection confirmation detection point CC1 on the first direct-current charging socket side are further used, to distinguish between the foregoing scenarios based on the two values, thereby improving detection accuracy.

### Embodiment 2

In a first scenario, that a status of the first direct-current charging gun and a status of the first direct-current charging socket are determined based on the first voltage value, the second voltage value, the third voltage value, and the fourth voltage value includes: when the first voltage value is 6 V, the second voltage value is 6 V, the third voltage value is 6 V, and the fourth voltage value is 6 V (for example, a state 2 in FIG. 7A), determining that the first direct-current charging gun is plugged into the first direct-current charging socket and a mechanical lock on the first direct-current charging gun is in a pressed state.

It may be understood that, when the first direct-current charging gun is plugged into the first direct-current charging socket and the mechanical lock on the first direct-current charging gun is pressed, a circuit connection is completed between a left half part (an interface of the first direct-current charging gun in this embodiment) of a vehicle interface circuit and a connection point 6 in a right half part (an interface of the first direct-current charging socket in this embodiment) of the vehicle interface circuit. In this case, the voltage value at the connection confirmation detection point CC1 on the first direct-current charging gun side is equal to the voltage value at the CC1 of the first direct-current charging socket, and the voltage value at the connection confirmation detection point CC2 on the first direct-current charging gun side is equal to the voltage value at the CC2 of the first direct-current charging socket. In addition, because the voltage value at the connection confirmation detection point CC1 on the first direct-current charging gun side is equal to 6 V, and the voltage value at the CC2 of the first direct-current charging socket is equal to 6 V, both the first voltage value and the third voltage value are equal to 6 V, and both the second voltage value and the fourth voltage value are equal to 6 V.

In a second scenario, that a status of the first direct-current charging gun and a status of the first direct-current charging socket are determined based on the first voltage value, the second voltage value, the third voltage value, and the fourth voltage value includes: when the first voltage value is 6 V, the second voltage value is not 0 V, the third voltage value is 4 V, and the fourth voltage value is 6 V (for example, a state 13 in FIG. 7B), determining that the first direct-current charging gun is plugged into a second direct-current charging socket and a mechanical lock on the first direct-current charging gun is in a pressed state, that a second direct-current charging gun is plugged into the first direct-current charging socket and the second direct-current charging gun is in a released state, and that the second direct-current charging socket is a direct-current charging socket of another device that needs to be charged.

In this embodiment, for concepts of the second direct-current charging gun and the second direct-current charging socket, refer to descriptions in Embodiment 1. Details are not described herein again.

It may be understood that, when the first direct-current charging gun is plugged into the second direct-current charging socket and the first mechanical lock is in a pressed state, a circuit connection is completed between a left half part (an interface of the first direct-current charging gun in this embodiment) of a vehicle interface circuit and a connection point 6 in a right half part (an interface of the second direct-current charging socket in this embodiment) of the vehicle interface circuit. In this case, the voltage value at the connection confirmation detection point CC1 on the first direct-current charging gun side is equal to a voltage value at a CC1 of the second direct-current charging socket, and the voltage value at the connection confirmation detection point CC2 on the first direct-current charging gun side is equal to a voltage value at a CC2 of the second direct-current charging socket. In addition, because the voltage value at the connection confirmation detection point CC1 on the first direct-current charging gun side is equal to 6 V, and the voltage value at the CC2 of the second direct-current charging socket is equal to 6 V, the first voltage value and the second voltage value are equal to 6 V.

When a direct-current charging gun (that is, the second direct-current charging gun) of another power supply device is plugged into the first direct-current charging socket and the mechanical lock on the second direct-current charging gun is in a released state, a circuit connection is completed between the left half part (an interface of the first direct-current charging gun in this embodiment) of the vehicle interface circuit and a connection point 1 to a connection point 9 in the right half part (an interface of the second direct-current charging socket in this embodiment) of the vehicle interface circuit. In this case, the voltage value at the connection confirmation detection point CC1 of the first direct-current charging socket is equal to a voltage value at a connection confirmation detection point CC1 on the second direct-current charging gun side, and the voltage value at the CC2 of the first direct-current charging socket is equal to 6 V. In addition, because the voltage value at the connection confirmation detection point CC1 on the second direct-current charging gun side is equal to 4 V, the voltage value (that is, the third voltage value) at the connection confirmation detection point CC1 on the first direct-current charging socket side is equal to 4 V, and the fourth voltage value is equal to 6 V.

In a third scenario, that a status of the first direct-current charging gun and a status of the first direct-current charging socket are determined based on the first voltage value, the second voltage value, the third voltage value, and the fourth voltage value includes: when the first voltage value is 6 V, the second voltage value is 0 V, the third voltage value is 6 V, and the fourth voltage value is 6 V (for example, a state 11 in FIG. 7B), determining that the first direct-current charging gun leaves the first direct-current charging socket and a mechanical lock on the first direct-current charging gun is in a released state, and that a second direct-current charging gun is plugged into the first direct-current charging socket and a mechanical lock on the second direct-current charging gun is in a pressed state.

It may be understood that, when the first direct-current charging gun leaves the first direct-current charging socket and the first mechanical lock is in a released state, the voltage value at the connection confirmation detection point CC1 on the first direct-current charging gun side is equal to 6 V. In addition, because the first direct-current charging gun is not connected to any direct-current charging socket, the voltage value at the connection confirmation detection point CC2 on the first direct-current charging gun side is equal to 0 V. In other words, the first voltage value is equal to 6 V, and the second voltage value is equal to 0 V.

When a direct-current charging gun (that is, the second direct-current charging gun) of another power supply device is plugged into the first direct-current charging socket and the mechanical lock on the second direct-current charging gun is in a pressed state, a circuit connection is completed between a left half part (an interface of the second direct-current charging gun in this embodiment) of a vehicle interface circuit and a connection point 6 in a right half part (an interface of the first direct-current charging socket in this embodiment) of the vehicle interface circuit. In this case, the voltage value at the connection confirmation detection point CC1 of the first direct-current charging socket is equal to a voltage value at a connection confirmation detection point CC1 on the second direct-current charging gun side, and the voltage value at the CC2 of the first direct-current charging socket is equal to 6 V. In addition, because the voltage value at the connection confirmation detection point CC1 on the second direct-current charging gun side is equal to 6 V, the third voltage value is equal to 6 V, and the fourth voltage value is equal to 6 V.

In a fourth scenario, that a status of the first direct-current charging gun and a status of the first direct-current charging socket are determined based on the first voltage value, the second voltage value, the third voltage value, and the fourth voltage value includes: when the first voltage value is 6 V, the second voltage value is 0 V, the third voltage value is 4 V, and the fourth voltage value is 6 V (for example, a state 6 in FIG. 7B), determining that the first direct-current charging gun leaves the first direct-current charging socket and a mechanical lock on the first direct-current charging gun is in a released state, and that a second direct-current charging gun is plugged into the first direct-current charging socket and a mechanical lock on the second direct-current charging gun is in a released state.

It may be understood that, when the first direct-current charging gun leaves the first direct-current charging socket and the first mechanical lock is in a released state, the voltage value at the connection confirmation detection point CC1 on the first direct-current charging gun side is equal to 6 V. In addition, because the first direct-current charging gun is not connected to any direct-current charging socket, the voltage value at the connection confirmation detection point CC1 on the first direct-current charging gun side is equal to 0 V. In other words, the first voltage value is equal to 6 V, and the second voltage value is equal to 0 V.

When a direct-current charging gun (that is, the second direct-current charging gun) of another power supply device is plugged into the first direct-current charging socket and the mechanical lock on the second direct-current charging gun is in a released state, a circuit connection is completed between a left half part (an interface of the second direct-current charging gun in this embodiment) of a vehicle interface circuit and a connection point 1 to a connection point 9 in a right half part (an interface of the first direct-current charging socket in this embodiment) of the vehicle interface circuit. In this case, the voltage value at the connection confirmation detection point CC1 of the first direct-current charging socket is equal to a voltage value at a connection confirmation detection point CC1 on the second direct-current charging gun side, and the voltage value at the CC2 of the first direct-current charging socket is equal to 6 V. In addition, because the voltage value at the connection confirmation detection point CC1 on the second direct-current charging gun side is equal to 4 V, the voltage value (that is, the third voltage value) at the connection confirmation detection point CC1 on the first direct-current charging socket side is equal to 4 V, and the fourth voltage value is equal to 6 V.

In the status detection method provided in this embodiment of this application, in the four scenarios, voltage values at the connection confirmation detection point CC1 on the first direct-current charging gun side all are equal to 4 V, and voltage values at the connection confirmation detection point CC2 on the first direct-current charging socket side all are equal to 6 V. In other words, in the conventional technology, if only the voltage value at the connection confirmation detection point CC1 on the first direct-current charging gun side and the voltage value at the connection confirmation detection point CC2 on the first direct-current charging socket side are used to detect plugging statuses of the first direct-current charging gun and the first direct-current charging socket, when detecting that the first voltage value is 6 V and the fourth voltage value is 6 V, the mobile charging device cannot accurately determine a specific scenario in which the voltage values are generated. Consequently, detection is inaccurate. However, in this embodiment, in addition to the voltage value at the connection confirmation detection point CC1 on the first direct-current charging gun side and the voltage value at the connection confirmation detection point CC2 on the first direct-current charging socket side, the voltage value at the connection confirmation detection point CC2 on the first direct-current charging gun side and the voltage value at the connection confirmation detection point CC1 on the first direct-current charging socket side are further used, to distinguish between the foregoing scenarios based on the two values, thereby improving detection accuracy.

### Embodiment 3

In a first scenario, that a status of the first direct-current charging gun and a status of the first direct-current charging socket are determined based on the first voltage value, the second voltage value, the third voltage value, and the fourth voltage value includes: when the first voltage value is 6 V, the second voltage value is 0 V, the third voltage value is 0 V, and the fourth voltage value is 12 V (for example, a state 4 in FIG. 7A), determining that the first direct-current charging gun leaves the first direct-current charging socket and a mechanical lock on the first direct-current charging gun is in a released state.

It may be understood that, when the first direct-current charging gun leaves the first direct-current charging socket and the first mechanical lock is in a released state, the voltage value at the connection confirmation detection point CC1 on the first direct-current charging gun side is equal to 6 V. In addition, because the first direct-current charging gun is not connected to any direct-current charging socket, the voltage value at the connection confirmation detection point CC2 on the first direct-current charging gun side is equal to 0 V. In other words, the first voltage value is equal to 6 V, and the second voltage value is equal to 0 V.

When no direct-current charging gun is plugged into the first direct-current charging socket, the voltage value at the connection confirmation detection point CC2 on the first direct-current charging socket side is equal to 12 V. In addition, because the first direct-current charging socket is not connected to any direct-current charging gun, the voltage value at the connection confirmation detection point CC1 on the first direct-current charging socket side is equal to 0 V. In other words, the third voltage value is equal to 0 V, and the second voltage value is equal to 12 V.

In a second scenario, that a status of the first direct-current charging gun and a status of the first direct-current charging socket are determined based on the first voltage value, the second voltage value, the third voltage value, and the fourth voltage value includes: when the first voltage value is 6 V, the second voltage value is not 0 V, the third voltage value is 0 V, and the fourth voltage value is 12 V (for example, a state 7 in FIG. 7A), determining that the first direct-current charging gun is plugged into a second direct-current charging socket and a first mechanical lock is in a pressed state, and that no direct-current charging gun is plugged into the first direct-current charging socket.

It may be understood that, when the first direct-current charging gun is plugged into the second direct-current charging socket and the first mechanical lock is in a pressed state, a circuit connection is completed between a left half part (an interface of the first direct-current charging gun in this embodiment) of a vehicle interface circuit and a connection point 6 in a right half part (an interface of the second direct-current charging socket in this embodiment) of the vehicle interface circuit. In this case, the voltage value at the connection confirmation detection point CC1 on the first direct-current charging gun side is equal to 6 V, and the voltage value at the connection confirmation detection point CC2 on the first direct-current charging gun side is equal to a voltage value at a CC2 of the second direct-current charging socket. In addition, because the voltage value at the CC2 of the second direct-current charging socket is equal to 6 V, the voltage value at the connection confirmation detection point CC2 on the first direct-current charging gun side is equal to 6 V. In other words, the first voltage value is equal to 6 V, and the second voltage value is not 0 V.

For the first direct-current charging socket, because no direct-current charging gun is plugged into the first direct-current charging socket, the third voltage value is equal to 0 V, and the second voltage value is equal to 12 V.

In the status detection method provided in this embodiment of this application, in the two scenarios, voltage values at the connection confirmation detection point CC1 on the first direct-current charging gun side both are 6 V, and voltage values at the connection confirmation detection point CC2 on the first direct-current charging socket side both are 12 V. In other words, in the conventional technology, if only the voltage value at the connection confirmation detection point CC 1 on the first direct-current charging gun side and the voltage value at the connection confirmation detection point CC2 on the first direct-current charging socket side are used to detect plugging statuses of the first direct-current charging gun and the first direct-current charging socket, when detecting that the first voltage value is 6 V and the fourth voltage value is 12 V, the mobile charging device cannot accurately determine a specific scenario in which the voltage values are generated. Consequently, detection is inaccurate. However, in this embodiment, in addition to the voltage value at the connection confirmation detection point CC1 on the first direct-current charging gun side and the voltage value at the connection confirmation detection point CC2 on the first direct-current charging socket side, the voltage value at the connection confirmation detection point CC2 on the first direct-current charging gun side and the voltage value at the connection confirmation detection point CC1 on the first direct-current charging socket side are further used, to distinguish between the foregoing scenarios based on the two values, thereby improving detection accuracy.

### Embodiment 4

In a first scenario, that a status of the first direct-current charging gun and a status of the first direct-current charging socket are determined based on the first voltage value, the second voltage value, the third voltage value, and the fourth voltage value includes: when the first voltage value is 12 volts, the second voltage value is 0 volts, the third voltage value is 6 volts, and the fourth voltage value is 6 volts (for example, a state 10 in FIG. 7B), determining that the first direct-current charging gun leaves the first direct-current charging socket and a mechanical lock on the first direct-current charging gun is in a pressed state, that a second direct-current charging gun is plugged into the first direct-current charging socket and a mechanical lock on the second direct-current charging gun is in a pressed state, and that the second direct-current charging gun is a direct-current charging gun of another power supply device.

It may be understood that, when the first direct-current charging gun leaves the first direct-current charging socket and the first mechanical lock is in a pressed state, the voltage value at the connection confirmation detection point CC1 on the first direct-current charging gun side is equal to 12 V. In addition, because the first direct-current charging gun is not connected to any direct-current charging socket, the voltage value at the connection confirmation detection point CC2 on the first direct-current charging gun side is equal to 0 V. In other words, the first voltage value is equal to 12 V, and the second voltage value is equal to 0 V.

When a direct-current charging gun (that is, the second direct-current charging gun) of another power supply device is plugged into the first direct-current charging socket and the mechanical lock on the second direct-current charging gun is in a pressed state, a circuit connection is completed between a left half part (an interface of the second direct-current charging gun in this embodiment) of a vehicle interface circuit and a connection point 6 in a right half part (an interface of the first direct-current charging socket in this embodiment) of the vehicle interface circuit. In this case, the voltage value at the connection confirmation detection point CC1 of the first direct-current charging socket is equal to a voltage value at a connection confirmation detection point CC1 on the second direct-current charging gun side, and the voltage value at the CC2 of the first direct-current charging socket is equal to 6 V. In addition, because the voltage value at the connection confirmation detection point CC1 on the second direct-current charging gun side is equal to 6 V, the third voltage value is equal to 6 V, and the fourth voltage value is equal to 6 V.

In a second scenario, that a status of the first direct-current charging gun and a status of the first direct-current charging socket are determined based on the first voltage value, the second voltage value, the third voltage value, and the fourth voltage value includes: when the first voltage value is 12 V, the second voltage value is 0 V, the third voltage value is 4 V, and the fourth voltage value is 6 V (for example, a state 5 in FIG. 7B), determining that the first direct-current charging gun leaves the first direct-current charging socket and a mechanical lock on the first direct-current charging gun is in a pressed state, and that a second direct-current charging gun is plugged into the first direct-current charging socket and a mechanical lock on the second direct-current charging gun is in a released state.

It may be understood that, when the first direct-current charging gun leaves the first direct-current charging socket and the first mechanical lock is in a pressed state, the voltage value at the connection confirmation detection point CC1 on the first direct-current charging gun side is equal to 12 V. In addition, because the first direct-current charging gun is not connected to any direct-current charging socket, the voltage value at the connection confirmation detection point CC2 on the first direct-current charging gun side is equal to 0 V. In other words, the first voltage value is equal to 12 V, and the second voltage value is equal to 0 V.

When a direct-current charging gun (that is, the second direct-current charging gun) of another power supply device is plugged into the first direct-current charging socket and the mechanical lock on the second direct-current charging gun is in a released state, a circuit connection is completed between a left half part (an interface of the second direct-current charging gun in this embodiment) of a vehicle interface circuit and a connection point 1 to a connection point 9 in a right half part (an interface of the first direct-current charging socket in this embodiment) of the vehicle interface circuit. In this case, the voltage value at the connection confirmation detection point CC1 of the first direct-current charging socket is equal to a voltage value at a connection confirmation detection point CC1 on the second direct-current charging gun side, and the voltage value at the CC2 of the first direct-current charging socket is equal to 6 V. In addition, because the voltage value at the connection confirmation detection point CC1 on the second direct-current charging gun side is equal to 4 V, the voltage value (that is, the third voltage value) at the connection confirmation detection point CC1 on the first direct-current charging socket side is equal to 4 V, and the fourth voltage value is equal to 6 V.

In the status detection method provided in this embodiment of this application, in the two scenarios, voltage values at the connection confirmation detection point CC1 on the first direct-current charging gun side both are 12 V, and voltage values at the connection confirmation detection point CC2 on the first direct-current charging socket side both are 4 V. In other words, in the conventional technology, if only the voltage value at the connection confirmation detection point CC1 on the first direct-current charging gun side and the voltage value at the connection confirmation detection point CC2 on the first direct-current charging socket side are used to detect plugging statuses of the first direct-current charging gun and the first direct-current charging socket, when detecting that the first voltage value is 12 V and the fourth voltage value is 4 V, the mobile charging device cannot accurately determine a specific scenario in which the voltage values are generated. Consequently, detection is inaccurate. However, in this embodiment, in addition to the voltage value at the connection confirmation detection point CC1 on the first direct-current charging gun side and the voltage value at the connection confirmation detection point CC2 on the first direct-current charging socket side, the voltage value at the connection confirmation detection point CC2 on the first direct-current charging gun side and the voltage value at the connection confirmation detection point CC1 on the first direct-current charging socket side are further used, to distinguish between the foregoing scenarios based on the two values, thereby improving detection accuracy.

In an optional embodiment, that a status of the first direct-current charging gun and a status of the first direct-current charging socket are determined based on the first voltage value, the second voltage value, the third voltage value, and the fourth voltage value includes: when the first voltage value is 12 V, the second voltage value is 0 V, the third voltage value is 0 V, and the fourth voltage value is 12 V (for example, a state 3 in FIG. 7A), determining that the first direct-current charging gun leaves the first direct-current charging socket and a mechanical lock on the first direct-current charging gun is in a pressed state.

It may be understood that, when the first direct-current charging gun leaves the first direct-current charging socket and the first mechanical lock is in a pressed state, the voltage value at the connection confirmation detection point CC1 on the first direct-current charging gun side is equal to 12 V. In addition, because the first direct-current charging gun is not connected to any direct-current charging socket, the voltage value at the connection confirmation detection point CC2 on the first direct-current charging gun side is equal to 0 V. In other words, the first voltage value is equal to 12 V, and the second voltage value is equal to 0 V.

When no direct-current charging gun is plugged into the first direct-current charging socket, the voltage value at the connection confirmation detection point CC2 on the first direct-current charging gun side is equal to 12 V. In addition, because the first direct-current charging gun is not connected to any direct-current charging socket, the voltage value at the connection confirmation detection point CC1 on the first direct-current charging gun side is equal to 0 V. In other words, the third voltage value is equal to 0 V, and the second voltage value is equal to 12 V.

Therefore, in the detection method provided in this embodiment, when learning that the first voltage value is 12 V, the second voltage value is 0 V, the third voltage value is 0 V, and the fourth voltage value is 12 V, the mobile charging device can determine that the first direct-current charging gun leaves the first direct-current charging socket and the first mechanical lock is in a pressed state.

In an optional embodiment, that a status of the first direct-current charging gun and a status of the first direct-current charging socket are determined based on the first voltage value, the second voltage value, the third voltage value, and the fourth voltage value includes: when the first voltage value is 4 V, the second voltage value is not 0 V, the third voltage value is 0 V, and the fourth voltage value is 12 V (for example, a state 8 in FIG. 7A), determining that the first direct-current charging gun is plugged into a second direct-current charging socket and a mechanical lock on the first direct-current charging gun is in a released state, and that no direct-current charging gun is plugged into the first direct-current charging socket.

It may be understood that, when the first direct-current charging gun is plugged into the second direct-current charging socket and the mechanical lock on the first direct-current charging gun is released, a circuit connection is completed between a left half part (an interface of the first direct-current charging gun in this embodiment) of a vehicle interface circuit and a connection point 1 to a connection point 9 in a right half part (an interface of the second direct-current charging socket in this embodiment) of the vehicle interface circuit. In this case, the voltage value at the connection confirmation detection point CC1 on the first direct-current charging gun side is equal to 4 V, and the voltage value at the connection confirmation detection point CC2 on the first direct-current charging gun side is equal to a voltage value at a CC2 of the second direct-current charging socket. In addition, because the voltage value at the CC2 of the second direct-current charging socket is equal to 6 V, the first voltage value is equal to 4 V, and the second voltage value is not equal to 0 V.

For the first direct-current charging socket, because no direct-current charging gun is plugged into the first direct-current charging socket, the third voltage value is equal to 0 V, and the second voltage value is equal to 12 V.

Therefore, in the detection method provided in this embodiment, when learning that the first voltage value is 4 V, the second voltage value is not 0 V, the third voltage value is 0 V, and the fourth voltage value is 12 V, the mobile charging device can determine that the first direct-current charging gun is plugged into the second direct-current charging socket and the first mechanical lock is in a released state, and that no direct-current charging gun is plugged into the first direct-current charging socket.

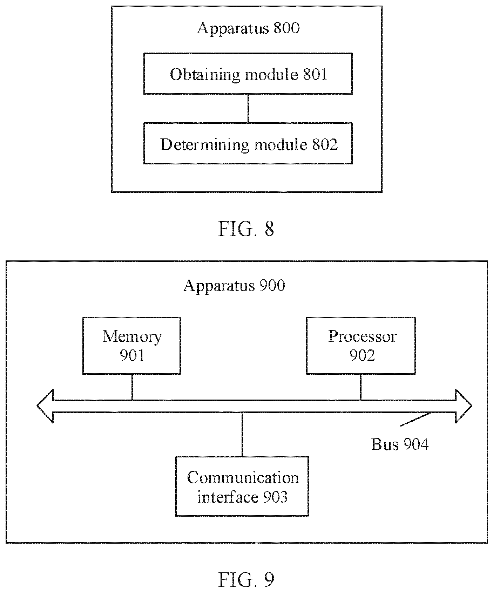

FIG. 8 is a schematic diagram of a detection apparatus according to an embodiment of this application. The apparatus is applied to a mobile charging device, the mobile charging device includes a first charging gun and a first charging socket, and the apparatus 800 includes an obtaining module 801 and a determining module 802.

The obtaining module 801 is configured to: obtain a first voltage value at a first connection confirmation detection point and a second voltage value at a second connection confirmation detection point in a control and guiding circuit of the first charging gun, and obtain a third voltage value at a first connection confirmation detection point and a fourth voltage value at a second connection confirmation detection point in a control and guiding circuit of the first charging socket. The determining module 802 is configured to determine a gun mounting status of the first charging gun and a gun mounting status of the first charging socket based on the first voltage value, the second voltage value, the third voltage value, and the fourth voltage value.

In a possible implementation, the first charging gun is a direct-current charging gun, and the first charging socket is a direct-current charging socket.

In a possible implementation, the determining module 802 is specifically configured to: when the first voltage value is 4 volts, the second voltage value is 6 volts, the third voltage value is 4 volts, and the fourth voltage value is 6 volts, determine that the first charging gun is plugged into the first charging socket and a mechanical lock on the first charging gun is in a released state.

In a possible implementation, the determining module 802 is further configured to: when the first voltage value is 6 volts, the second voltage value is 6 volts, the third voltage value is 6 volts, and the fourth voltage value is 6 volts, determine that the first charging gun is plugged into the first charging socket and the mechanical lock on the first charging gun is in a pressed state.

In a possible implementation, the determining module 802 is further configured to: when the first voltage value is 12 volts, the second voltage value is 0 volts, the third voltage value is 0 volts, and the fourth voltage value is 12 volts, determine that the first charging gun leaves the first charging socket and the mechanical lock on the first charging gun is in a pressed state.

In a possible implementation, the determining module 802 is further configured to: when the first voltage value is 6 volts, the second voltage value is 0 volts, the third voltage value is 0 volts, and the fourth voltage value is 12 volts, determine that the first charging gun leaves the first charging socket and the mechanical lock on the first charging gun is in a released state.

In a possible implementation, the determining module 802 is further configured to: when the first voltage value is 12 volts, the second voltage value is 0 volts, the third voltage value is 6 volts, and the fourth voltage value is 6 volts, determine that the first charging gun leaves the first charging socket and the mechanical lock on the first charging gun is in a pressed state, that a second charging gun is plugged into the first charging socket and a mechanical lock on the second charging gun is in a pressed state, and that the second charging gun is a charging gun of another power supply device.

In a possible implementation, the determining module 802 is further configured to: when the first voltage value is 12 volts, the second voltage value is 0 volts, the third voltage value is 4 volts, and the fourth voltage value is 6 volts, determine that the first charging gun leaves the first charging socket and the mechanical lock on the first charging gun is in a pressed state, and that the second charging gun is plugged into the first charging socket and the mechanical lock on the second charging gun is in a released state.

In a possible implementation, the determining module 802 is further configured to: when the first voltage value is 6 volts, the second voltage value is not 0 volts, the third voltage value is 4 volts, and the fourth voltage value is 6 volts, determine that the first charging gun is plugged into a second charging socket and the mechanical lock on the first charging gun is in a pressed state, that the second charging gun is plugged into the first charging socket and the second charging gun is in a released state, and that the second charging socket is a charging socket of another device that needs to be charged.

In a possible implementation, the determining module 802 is further configured to: when the first voltage value is 6 volts, the second voltage value is 0 volts, the third voltage value is 6 volts, and the fourth voltage value is 6 volts, determine that the first charging gun leaves the first charging socket and the mechanical lock on the first charging gun is in a released state, and that the second charging gun is plugged into the first charging socket and the mechanical lock on the second charging gun is in a pressed state.

In a possible implementation, the determining module 802 is further configured to: when the first voltage value is 6 volts, the second voltage value is 0 volts, the third voltage value is 4 volts, and the fourth voltage value is 6 volts, determine that the first charging gun leaves the first charging socket and the mechanical lock on the first charging gun is in a released state, and that the second charging gun is plugged into the first charging socket and the mechanical lock on the second charging gun is in a released state.

In a possible implementation, the determining module 802 is further configured to: when the first voltage value is 6 volts, the second voltage value is not 0 volts, the third voltage value is 0 volts, and the fourth voltage value is 12 volts, determine that the first charging gun is plugged into the second direct-current charging socket and the first mechanical lock is in a pressed state, and that no charging gun is plugged into the first charging socket.

In a possible implementation, the determining module 802 is further configured to: when the first voltage value is 4 volts, the second voltage value is not 0 volts, the third voltage value is 0 volts, and the fourth voltage value is 12 volts, determine that the first charging gun is plugged into the second charging socket and the mechanical lock on the first charging gun is in a released state, and that no charging gun is plugged into the first charging socket.

In a possible implementation, the determining module 802 is further configured to: when the first voltage value is 4 volts, the second voltage value is not 0 volts, the third voltage value is 6 volts, and the fourth voltage value is 6 volts, determine that the first charging gun is plugged into the second charging socket and the mechanical lock on the first charging gun is in a released state, and that the second charging gun is plugged into the first charging socket and the mechanical lock on the second charging gun is in a pressed state.

In a possible implementation, the determining module 802 is further configured to: when the first voltage value is 4 volts, the second voltage value is not 0 volts, the third voltage value is 4 volts, and the fourth voltage value is 6 volts, determine that the first charging gun is plugged into the second charging socket and the mechanical lock on the first charging gun is in a released state, and that the second charging gun is plugged into the first charging socket and the mechanical lock on the second charging gun is in a released state.

In a possible implementation, the charging device includes a first controller, the control and guiding circuit of the first charging gun includes a resistor R3, the control and guiding circuit of the first charging socket includes a resistor R4, the second connection confirmation detection point of the first charging gun is connected to the resistor R3 and the first controller, and the first connection confirmation detection point of the first charging socket is connected to the resistor R4 and the first controller.

In a possible implementation, the charging device is a mobile charging device.

FIG. 9 is a schematic diagram of a detection apparatus according to another embodiment of this application. The apparatus shown in FIG. 9 may be configured to perform the method described in any of the foregoing embodiments.

As shown in FIG. 9, an apparatus 900 in this embodiment includes a memory 901, a processor 902, a communication interface 903, and a bus 904. A communication connection between the memory 901, the processor 902, and the communication interface 903 is implemented by using the bus 904.

The memory 901 may be a read-only memory (read-only memory, ROM), a static storage device, a dynamic storage device, or a random access memory (random access memory, RAM). The memory 901 may store a program. When the program stored in the memory 901 is executed by the processor 902, the processor 902 is configured to perform the steps of the method shown in FIG. 5.

The processor 902 may be a general-purpose central processing unit (central processing unit, CPU), a microprocessor, an application-specific integrated circuit (application-specific integrated circuit, ASIC), or one or more integrated circuits, and is configured to execute a related program to implement the method shown in FIG. 5 in this application.

The processor 902 may alternatively be an integrated circuit chip, and has a signal processing capability. In an implementation process, the steps of the method in FIG. 5 in this embodiment of this application may be completed by using an integrated logic circuit of hardware in the processor 902 or instructions in a software form.

Alternatively, the processor 902 may be a general-purpose processor, a digital signal processor (digital signal processor, DSP), an application-specific integrated circuit (ASIC), a field programmable gate array (field programmable gate array, FPGA) or another programmable logic device, a discrete gate or a transistor logic device, or a discrete hardware component. The processor 902 can implement or perform the methods, the steps, and the logical block diagrams that are disclosed in embodiments of this application. The general-purpose processor may be a microprocessor, or the processor may be any conventional processor or the like.

The steps of the methods disclosed with reference to embodiments of this application may be directly executed and completed by using a hardware decoding processor, or may be executed and completed by using a combination of hardware and software modules in the decoding processor. The software module may be located in a mature storage medium in the art, such as a random access memory, a flash memory, a read-only memory, a programmable read-only memory, an electrically erasable programmable memory, or a register. The storage medium is located in the memory 901. The processor 902 reads information in the memory 901, and completes, in combination with hardware of the processor 902, functions that need to be performed by units included in the apparatus in this application. For example, the processor 902 may perform the steps/functions in the embodiment shown in FIG. 5.

The communication interface 903 may use, but not limited to, a transceiver apparatus of a transceiver type, to implement communication between the apparatus 900 and another device or a communication network.

The bus 904 may include a path for transmitting information between the components (for example, the memory 901, the processor 902, and the communication interface 903) of the apparatus 900.

It should be understood that the apparatus 900 shown in this embodiment of this application may be an electronic device, or may be a chip configured in an electronic device.

All or some of the foregoing embodiments may be implemented by using software, hardware, firmware, or any combination thereof. When software is used for implementation, the foregoing embodiments may be entirely or partially implemented in a form of a computer program product. The computer program product includes one or more computer instructions or computer programs. When the computer instructions or the computer programs are loaded or executed on a computer, all or some of the procedures or functions according to embodiments of this application are generated. The computer may be a general-purpose computer, a dedicated computer, a computer network, or another programmable apparatus. The computer instructions may be stored in a computer-readable storage medium, or transmitted from one computer-readable storage medium to another computer-readable storage medium. For example, the computer instructions may be transmitted from one website, computer, server, or data center to another website, computer, server, or data center in a wired (for example, infrared, radio, or microwave) manner. The computer-readable storage medium may be any available medium accessible to a computer, or a data storage device, such as a server or a data center, integrating one or more available media. The available medium may be a magnetic medium (for example, a floppy disk, a hard disk, or a magnetic tape), an optical medium (for example, a DVD), or a semiconductor medium. The semiconductor medium may be a solid-state drive.

It should be understood that the term "and/or" in this specification describes only an association relationship between associated objects and represents that three relationships may exist. For example, "A and/or B" may represent the following three cases: Only A exists, both A and B exist, and only B exists, where A and B may be singular or plural. The character "/" in this specification usually indicates an "or" relationship between associated objects, but may also indicate an "and/or" relationship. For details, refer to the foregoing and subsequent descriptions for understanding.

In this application, "at least one" means one or more, and "a plurality of" means two or more. "At least one of the following items" or a similar expression thereof means any combination of these items, including a singular item or any combination of plural items. For example, at least one of a, b, or c may indicate a, b, c, a and b, a and c, b and c, or a, b, and c, where a, b, and c may be singular or plural.

It should be understood that, in various embodiments of this application, sequence numbers of the foregoing processes do not mean execution sequences. The execution sequences of the processes should be determined by functions and internal logic of the processes, and do not constitute any limitation on implementation processes of embodiments of this application.

A person of ordinary skill in the art may be aware that, the units and the algorithm steps in the examples described with reference to embodiments disclosed in this specification can be implemented by electronic hardware or a combination of computer software and electronic hardware. Whether the functions are performed by hardware or software depends on particular applications and design constraints of the technical solutions. A skilled person may use different methods to implement the described functions for each particular application, but this implementation should not be considered as beyond the scope of this application.

It may be clearly understood by a person skilled in the art that, for convenient and brief description, for specific working processes of the system, apparatus, and unit described above, refer to corresponding processes in the foregoing method embodiments. Details are not described herein again.

In the several embodiments provided in this application, it should be understood that the disclosed system, apparatus, and method may be implemented in other manners. For example, the apparatus embodiments described above are merely examples. For example, division of the units is merely logical function division, and there may be another division manner in actual implementation. For example, a plurality of units or components may be combined or integrated into another system, or some features may be ignored or not performed. In addition, the displayed or discussed mutual couplings or direct couplings or communication connections may be implemented through some interfaces. The indirect couplings or communication connections between the apparatuses or units may be implemented in an electrical form, a mechanical form, or another form.

The units described as separate parts may or may not be physically separate, and parts displayed as units may or may not be physical units, that is, may be located in one place, or may be distributed on a plurality of network units. Some or all of the units may be selected based on actual requirements to achieve the objectives of the solutions of embodiments.

In addition, functional units in embodiments of this application may be integrated into one processing unit, each of the units may exist alone physically, or two or more units may be integrated into one unit.

When the function is implemented in a form of a software functional unit and sold or used as an independent product, the function may be stored in a computer-readable storage medium. Based on such an understanding, the technical solutions in this application essentially, or the part contributing to the conventional technology, or some of the technical solutions may be implemented in a form of a software product. The computer software product is stored in a storage medium, and includes several instructions for instructing a computer device (which may be a personal computer, a server, a network device, or the like) to perform all or some of the steps of the methods in embodiments of this application. The foregoing storage medium includes any medium that can store program code, such as a USB flash drive, a removable hard disk, a read-only memory, a random access memory, a magnetic disk, or an optical disc.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A method for detecting a gun mounting status, applied to a charging device, wherein the charging device comprises a first charging gun and a first charging socket, and the method comprises:
obtaining a first voltage value at a first connection confirmation detection point and a second voltage value at a second connection confirmation detection point in a control and guiding circuit of the first charging gun;
obtaining a third voltage value at a first connection confirmation detection point and a fourth voltage value at a second connection confirmation detection point in a control and guiding circuit of the first charging socket; and
determining a gun mounting status of the first charging gun and a gun mounting status of the first charging socket based on the first voltage value, the second voltage value, the third voltage value, and the fourth voltage value.

2. The method according to claim 1, wherein the first charging gun is a direct-current charging gun, and the first charging socket is a direct-current charging socket.

3. The method according to claim 2, wherein the determining a gun mounting status of the first charging gun and a gun mounting status of the first charging socket based on the first voltage value, the second voltage value, the third voltage value, and the fourth voltage value comprises:
when the first voltage value is 4 volts, the second voltage value is 6 volts, the third voltage value is 4 volts, and the fourth voltage value is 6 volts, determining that the first charging gun is plugged into the first charging socket and a mechanical lock on the first charging gun is in a released state.

4. The method according to claim 3, wherein the determining a gun mounting status of the first charging gun and a gun mounting status of the first charging socket based on the first voltage value, the second voltage value, the third voltage value, and the fourth voltage value further comprises:
when the first voltage value is 6 volts, the second voltage value is 6 volts, the third voltage value is 6 volts, and the fourth voltage value is 6 volts, determining that the first charging gun is plugged into the first charging socket and the mechanical lock on the first charging gun is in a pressed state.

5. The method according to claim 3 or 4, wherein the determining a gun mounting status of the first charging gun and a gun mounting status of the first charging socket based on the first voltage value, the second voltage value, the third voltage value, and the fourth voltage value further comprises:
when the first voltage value is 12 volts, the second voltage value is 0 volts, the third voltage value is 0 volts, and the fourth voltage value is 12 volts, determining that the first charging gun leaves the first charging socket and the mechanical lock on the first charging gun is in a pressed state.

6. The method according to any one of claims 3 to 5, wherein the determining a gun mounting status of the first charging gun and a gun mounting status of the first charging socket based on the first voltage value, the second voltage value, the third voltage value, and the fourth voltage value further comprises:
when the first voltage value is 6 volts, the second voltage value is 0 volts, the third voltage value is 0 volts, and the fourth voltage value is 12 volts, determining that the first charging gun leaves the first charging socket and the mechanical lock on the first charging gun is in a released state.

7. The method according to any one of claims 3 to 6, wherein the determining a gun mounting status of the first charging gun and a gun mounting status of the first charging socket based on the first voltage value, the second voltage value, the third voltage value, and the fourth voltage value further comprises:
when the first voltage value is 12 volts, the second voltage value is 0 volts, the third voltage value is 6 volts, and the fourth voltage value is 6 volts, determining that the first charging gun leaves the first charging socket and the mechanical lock on the first charging gun is in a pressed state, that a second charging gun is plugged into the first charging socket and a mechanical lock on the second charging gun is in a pressed state, and that the second charging gun is a charging gun of another power supply device.

8. The method according to any one of claims 3 to 7, wherein the determining a gun mounting status of the first charging gun and a gun mounting status of the first charging socket based on the first voltage value, the second voltage value, the third voltage value, and the fourth voltage value further comprises:
when the first voltage value is 12 volts, the second voltage value is 0 volts, the third voltage value is 4 volts, and the fourth voltage value is 6 volts, determining that the first charging gun leaves the first charging socket and the mechanical lock on the first charging gun is in a pressed state, and that the second charging gun is plugged into the first charging socket and the mechanical lock on the second charging gun is in a released state.

9. The method according to any one of claims 3 to 8, wherein the determining a gun mounting status of the first charging gun and a gun mounting status of the first charging socket based on the first voltage value, the second voltage value, the third voltage value, and the fourth voltage value further comprises:
when the first voltage value is 6 volts, the second voltage value is not 0 volts, the third voltage value is 4 volts, and the fourth voltage value is 6 volts, determining that the first charging gun is plugged into a second charging socket and the mechanical lock on the first charging gun is in a pressed state, that the second charging gun is plugged into the first charging socket and the second charging gun is in a released state, and that the second charging socket is a charging socket of another device that needs to be charged.

10. The method according to any one of claims 3 to 9, wherein the determining a gun mounting status of the first charging gun and a gun mounting status of the first charging socket based on the first voltage value, the second voltage value, the third voltage value, and the fourth voltage value further comprises:
when the first voltage value is 6 volts, the second voltage value is 0 volts, the third voltage value is 6 volts, and the fourth voltage value is 6 volts, determining that the first charging gun leaves the first charging socket and the mechanical lock on the first charging gun is in a released state, and that the second charging gun is plugged into the first charging socket and the mechanical lock on the second charging gun is in a pressed state.

11. The method according to any one of claims 3 to 10, wherein the determining a gun mounting status of the first charging gun and a gun mounting status of the first charging socket based on the first voltage value, the second voltage value, the third voltage value, and the fourth voltage value further comprises:
when the first voltage value is 6 volts, the second voltage value is 0 volts, the third voltage value is 4 volts, and the fourth voltage value is 6 volts, determining that the first charging gun leaves the first charging socket and the mechanical lock on the first charging gun is in a released state, and that the second charging gun is plugged into the first charging socket and the mechanical lock on the second charging gun is in a released state.

12. The method according to any one of claims 3 to 11, wherein the determining a gun mounting status of the first charging gun and a gun mounting status of the first charging socket based on the first voltage value, the second voltage value, the third voltage value, and the fourth voltage value further comprises:
when the first voltage value is 6 volts, the second voltage value is not 0 volts, the third voltage value is 0 volts, and the fourth voltage value is 12 volts, determining that the first charging gun is plugged into the second charging socket and the first mechanical lock is in a pressed state, and that no charging gun is plugged into the first charging socket.

13. The method according to any one of claims 3 to 12, wherein the determining a gun mounting status of the first charging gun and a gun mounting status of the first charging socket based on the first voltage value, the second voltage value, the third voltage value, and the fourth voltage value further comprises:
when the first voltage value is 4 volts, the second voltage value is not 0 volts, the third voltage value is 0 volts, and the fourth voltage value is 12 volts, determining that the first charging gun is plugged into the second charging socket and the mechanical lock on the first charging gun is in a released state, and that no charging gun is plugged into the first charging socket.

14. The method according to any one of claims 3 to 13, wherein the determining a gun mounting status of the first charging gun and a gun mounting status of the first charging socket based on the first voltage value, the second voltage value, the third voltage value, and the fourth voltage value further comprises:
when the first voltage value is 4 volts, the second voltage value is not 0 volts, the third voltage value is 6 volts, and the fourth voltage value is 6 volts, determining that the first charging gun is plugged into the second charging socket and the mechanical lock on the first charging gun is in a released state, and that the second charging gun is plugged into the first charging socket and the mechanical lock on the second charging gun is in a pressed state.

15. The method according to any one of claims 3 to 14, wherein the determining a gun mounting status of the first charging gun and a gun mounting status of the first charging socket based on the first voltage value, the second voltage value, the third voltage value, and the fourth voltage value further comprises:
when the first voltage value is 4 volts, the second voltage value is not 0 volts, the third voltage value is 4 volts, and the fourth voltage value is 6 volts, determining that the first charging gun is plugged into the second charging socket and the mechanical lock on the first charging gun is in a released state, and that the second charging gun is plugged into the first charging socket and the mechanical lock on the second charging gun is in a released state.

16. The method according to any one of claims 2 to 15, wherein the charging device comprises a first controller, the control and guiding circuit of the first charging gun comprises a resistor R3, the control and guiding circuit of the first charging socket comprises a resistor R4, the second connection confirmation detection point of the first charging gun is connected to the resistor R3 and the first controller, and the first connection confirmation detection point of the first charging socket is connected to the resistor R4 and the first controller.

17. The method according to any one of claims 1 to 16, wherein the charging device is a mobile charging device.

18. An apparatus for detecting a gun mounting status, wherein the apparatus comprises a module configured to perform the method according to any one of claims 1 to 17.

19. An apparatus for detecting a gun mounting status, comprising a memory and a processor, wherein
the memory is configured to store program instructions; and
the processor is configured to invoke the program instructions in the memory, to perform the method according to any one of claims 1 to 17.

20. A computer-readable medium, wherein the computer-readable medium stores program code used to be executed by a computer, and the program code comprises instructions used to perform the method according to any one of claims 1 to 17.

21. A computer program product, wherein the computer program product comprises computer program code, and when the computer program code is run on a computer, the computer is enabled to implement the method according to any one of claims 1 to 17.
